(19) Europäisches Patentamt
European Patent Office
Office européen des brevets

(11) EP 2 484 739 A1

(12) # EUROPEAN PATENT APPLICATION
published in accordance with Art. 153(4) EPC

(43) Date of publication:
**08.08.2012 Bulletin 2012/32**

(21) Application number: **10820557.6**

(22) Date of filing: **29.09.2010**

(51) Int Cl.:
***C09J 201/00*** (2006.01) ***C09J 7/02*** (2006.01)
***C09J 9/02*** (2006.01) ***C09J 11/04*** (2006.01)
***C09J 11/06*** (2006.01) ***C09J 133/02*** (2006.01)
***C09J 163/00*** (2006.01) ***C09J 171/10*** (2006.01)
***C09J 179/08*** (2006.01) ***H01B 5/16*** (2006.01)
***H01L 21/60*** (2006.01) ***H01R 11/01*** (2006.01)
***H01R 43/00*** (2006.01) ***H05K 1/14*** (2006.01)
***H05K 3/32*** (2006.01) ***H05K 3/36*** (2006.01)

(86) International application number:
**PCT/JP2010/066914**

(87) International publication number:
**WO 2011/040442 (07.04.2011 Gazette 2011/14)**

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(30) Priority: **30.09.2009 JP 2009227062**

(71) Applicant: **Sumitomo Bakelite Company Limited**
**Shinagawa-ku**
**Tokyo 140-0002 (JP)**

(72) Inventors:
- **CHUMA Toshiaki**
**Tokyo 140-0002 (JP)**
- **OKADA Wataru**
**Tokyo 140-0002 (JP)**
- **KAGIMOTO Tomohiro**
**Tokyo 140-0002 (JP)**

(74) Representative: **HOFFMANN EITLE**
**Patent- und Rechtsanwälte**
**Arabellastrasse 4**
**81925 München (DE)**

(54) **CONDUCTIVE CONNECTION MATERIAL, METHOD FOR CONNECTION BETWEEN TERMINALS AND METHOD FOR MANUFACTURING CONNECTING TERMINAL**

(57) The present invention provides a conductive connecting material having a multi-layered structure comprising a resin composition and a metal foil selected from a solder foil or a tin foil, wherein the minimum ion viscosity value of the resin composition is 4-9 when measured in accordance with ASTM standard E2039 by applying a frequency of 10000Hz at the melting point of the metal foil. The present invention further provides a method for connecting terminals and a method for producing a connection terminal using the conductive connecting material. By using the conductive connecting material of the present invention, good electric connection between connection terminals as well as highly-reliable insulation between adjacent terminals can be achieved.

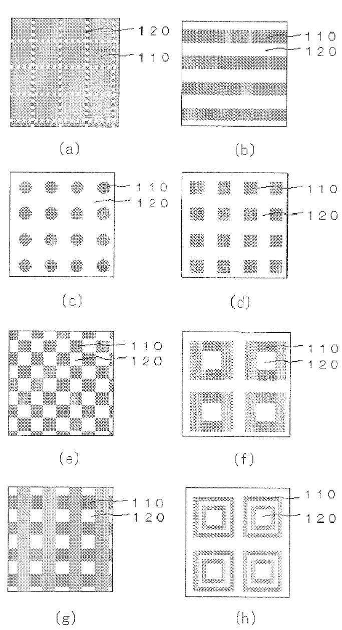


Fig. 1

EP 2 484 739 A1

## Description

TECHNICAL FIELD

The present invention relates to a conductive connecting material used for electrically connecting electronic members in an electrical or electronic component, to a method for connecting terminals and to a method for producing a connection terminal, using the conductive connecting material.

BACKGROUND ART

Recently, in association with the needs for enhanced performance and downsizing of electronic devices, pitch between the connection terminals of an electronic material is becoming narrower and narrower. Along with this, terminal-to-terminal connection in a fine pitch circuit has also been highly developed. As a method for connecting terminals, for example, flip chip connection techniques are known in which an anisotropic conductive adhesive or film is used to collectively connect a plurality of terminals for electrically connecting an IC chip to a circuit board. The anisotropic conductive adhesive or film is a film or a paste having conductive particles dispersed in an adhesive consisting mainly of a thermosetting resin (see, for example, Japanese Patent Unexamined Application Publication No. Showa 61-276873 (Patent Document 1) and Japanese Patent Unexamined Application Publication No. 2004-260131 (Patent Document 2)). This is arranged between the electronic members to be connected which are then subjected to thermal compression, thereby collectively connecting a plurality of opposing terminals and ensuring insulation between the adjacent terminals with the resin contained in the adhesive.

However, since controlling aggregation of the conductive particles is very difficult, (1) a part of the opposing terminals may not connected with each other due to insufficient contact between the conductive particles and the terminals or between the conductive particles, and (2) a leakage current may be caused due to the residual conductive particles in a region (insulating region) of the resin other than the region (conductive region) between the opposing terminals, resulting in inadequate insulation between the adjacent terminals. Accordingly, the conventional anisotropic conductive adhesives and films have difficulty in coping with terminals at narrower pitch.

On the other hand, in a case where a connection terminal is to be produced on an electrode of an electronic member, conventionally, a solder paste is printed on a substrate provided with a metal pad, and the solder paste is heat-melted with a solder reflow apparatus to form the connection terminal. However, according to this method, the cost of the mask used upon printing the solder paste is increased for connection terminals arranged at narrower pitch. In addition, when the size of the connection terminal is too small, the solder paste may not be able to be printed.

There is also a method for producing a connection terminal where a solder ball is mounted on the connection terminal and heat-melted using a solder reflow apparatus. According to this method, however, if the connection terminal is too small, production cost of the solder ball is increased. Moreover, a solder ball with a small diameter has often been technically difficult to produce.

PRIOR ART DOCUMENTS

[Patent Documents]

[Patent Document 1] Japanese Patent Unexamined Application Publication No. Showa 61-276873

[Patent Document 2] Japanese Patent Unexamined Application Publication No. 2004-260131

SUMMARY OF THE INVENTION

[Problems to be Solved by the Invention]

Under such circumstances, a conductive connecting material has been expected that can realize favorable electric connection between connection terminals and highly-reliable insulation between adjacent terminals. In addition, a convenient method for producing a connection terminal on an electrode of an electronic member has also been desired.

MEANS FOR SOLVING THE PROBLEMS

In order to solve the above-described problems, the present inventors have gone through intensive investigation, and, as a result of which, found that the use of a solder foil or a tin foil instead of conductive particles eases aggregation

of solder or tin between the terminals, and prevents the solder or tin to remain in the resin.
Furthermore, the present inventors took particular note of dynamic change in the viscosity of a resin composition at a melting point of a metal foil (metal layer). For example, when a semiconductor device is packaged on a substrate, it may instantly be exposed to a high temperature of 250˚C or higher by an IR reflow apparatus, and thus it is important to examine the composition of the resin composition in consideration of the temperature profile upon use.
Accordingly, the present inventors monitored the change in the viscosity of the resin composition with respect to the change in the temperature (i.e., rheology) by dielectric analysis to examine the effect on the formation of the conductive and insulating regions. As a result, when the minimum ion viscosity value of a resin composition at the melting point of the metal foil lies within a certain range, solder or tin can easily aggregate between the terminals and solder or tin can be prevented from remaining in the resin, thereby realizing excellent properties for forming conductive and insulating regions, excellent electric connection between the connection terminals, and highly-reliable insulation between the adjacent terminals. Furthermore, when a curable resin composition is used as the resin composition, it was found that abrupt curing of the resin composition can be suppressed while electric connection and insulation reliability can further be improved by using a composition whose maximum peak of the ion viscosity slope of the resin composition appears after a certain period of time from the initiation of measurement,.
Therefore, the present inventors found that by using a resin composition having the above-described behavior at the melting point of the metal foil as a resin composition layer in a conductive connecting material, connection between the terminals as well as production of a connection terminal in an electrical or electronic component become easier and insulation reliability thereof becomes higher, thereby accomplishing the present invention. Furthermore, when thermogravimetric weight loss of a resin composition lies within a certain range, generation of contamination and void due to outgassing can be suppressed and occurrence of crack in the package can be prevented, thereby acquiring high packaging reliability.

Thus, the present invention provides a conductive connecting material, a method for connecting terminals using the conductive connecting material, a method for producing a connection terminal, and an electrical or electronic component electrically connected using the conductive connecting material, described below.

(1) A conductive connecting material having a multi-layered structure comprising a resin composition and a metal foil selected from a solder foil or a tin foil, wherein the minimum ion viscosity value of the resin composition is 4-9 when measured in accordance with ASTM standard E2039 by applying a frequency of 10000Hz at the melting point of the metal foil.
(2) The conductive connecting material according to (1), wherein the maximum peak of the ion viscosity slope of the resin composition appears 10 or more seconds from the initiation of the measurement when measured in accordance with ASTM standard E2039 by applying a frequency of 10000Hz at the melting point of the metal foil.
(3) The conductive connecting material according to (1) or (2), wherein the thermogravimetric weight loss of the resin composition is 5% by weight or less when measured by heating from 30˚C to the melting point of the metal foil at a temperature rising rate of 10˚C/min.
(4) The conductive connecting material according to any one of (1)-(3), wherein the resin composition comprises an epoxy resin and a curing agent.
(5) The conductive connecting material according to (4), wherein the curing agent comprises at least one type selected from the group consisting of phenols, acid anhydrides and amine compounds.
(6) The conductive connecting material according to any one of (1)-(5), wherein the resin composition further comprises a film-forming resin.
(7) The conductive connecting material according to (6), wherein a weight-average molecular weight of the film-forming resin is 8,000-1,1,000,000.
(8) The conductive connecting material according to (6) or (7), wherein the film-forming resin comprises at least one type selected from the group consisting of a phenoxy resin, a (meth)acrylic resin and a polyimide resin.
(9) The conductive connecting material according to any one of (1)-(8), wherein the resin composition comprises, with respect to the total weight of the resin composition, 10-90% by weight of the epoxy resin, 0.1-50% by weight of the curing agent and 5-50% by weight of the film-forming resin.
(10) The conductive connecting material according to any one of (1)-(9), wherein the resin composition comprises a compound having a fluxing function.
(11) The conductive connecting material according to (10), wherein the compound having the fluxing function comprises a phenolic hydroxyl group and/or a carboxyl group.
(12) The conductive connecting material according to (10) or (11), wherein the compound having the fluxing function comprises a compound represented by General Formula (1) below:

$$HOOC\text{-}(CH_2)n\text{-}COOH \qquad (1)$$

where n is an integer of 1-20.

(13) The conductive connecting material according to (10) or (11), wherein the compound having the fluxing function comprises a compound represented by General Formula (2) and/or (3) below:

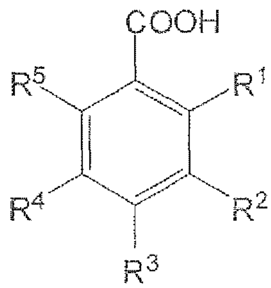

(2)

where $R^1$-$R^5$ each independently represent a monovalent organic group, providing that at least one of $R^1$-$R^5$ is a hydroxyl group,

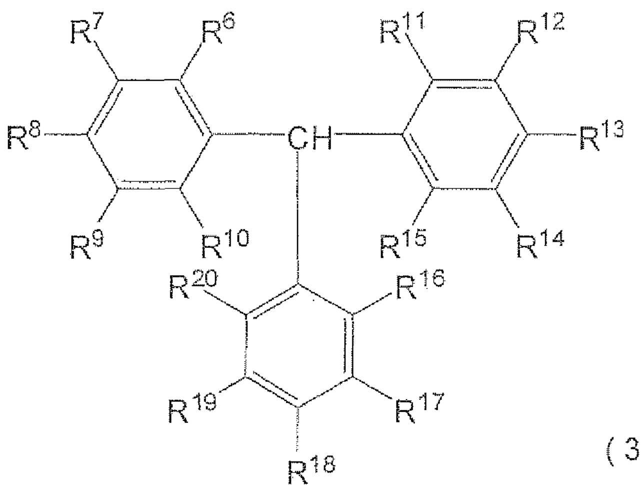

(3)

where $R^6$-$R^{20}$ each independently represent a monovalent organic group, providing that at least one of $R^6$-$R^{20}$ is a hydroxyl group or a carboxyl group.

(14) The conductive connecting material according to any one of (10)-(13), wherein the resin composition comprises the compound having the fluxing function for a total of 1-50% by weight with respect to the total weight of the resin composition.

(15) The conductive connecting material according to any one of (1)-(14), wherein the melting point of the metal foil is 100˚C-330˚C.

(16) The conductive connecting material according to any one of (1)-(15), comprising a multi-layered structure comprising resin composition layer/metal foil layer/resin composition layer.

(17) The conductive connecting material according to any one of (1)-(15), comprising a multi-layered structure comprising resin composition layer/metal foil layer.

(18) A method for connecting terminals, comprising the steps of: arranging the conductive connecting material according to any one of (1)-(17) between the opposing terminals; heating the conductive connecting material at a temperature that is equal to or higher than the melting point of the metal foil but that does not complete curing of the resin composition; and curing the resin composition.

(19) A method for connecting terminals, comprising the steps of: arranging the conductive connecting material according to any one of (1)-(17) between opposing terminals; heating the conductive connecting material at a temperature that is equal to or higher than the melting point of the metal foil and that softens the resin composition; and solidifying the resin composition.

(20) A method for producing a connection terminal, comprising the steps of: arranging the conductive connecting material according to any one of (1)-(17) on an electrode of an electronic member; and heating the conductive connecting material at a temperature that is equal to or higher than the melting point of the metal foil but that does not complete curing of the resin composition.

(21) A method for producing a connection terminal, comprising the steps of: arranging the conductive connecting material according to any one of (1)-(17) on an electrode of an electronic member; heating the conductive connecting material at a temperature that is equal to or higher than the melting point of the metal foil and that softens the resin composition; and solidifying the resin composition.
(22) An electronic member associated with a conductive connecting material, wherein the conductive connecting material according to any one of (1)-(17) is adhered to an electrically connecting surface of the electronic member.
(23) An electrical or electronic component, wherein electronic members are electrically connected using the conductive connecting material according to any one of (1)-(17).

EFFECT OF INVENTION

By using a conductive connecting material of the present invention, solder or tin can easily be aggregated between opposing terminals, thereby obtaining good electric connection. Furthermore, since a metal foil is used, conductive particles can be prevented from remaining in the insulating region, thereby obtaining highly-reliable insulation. In a preferable aspect of the present invention, a plurality of terminals in a fine pitch circuit such as a semiconductor device can be collectively connected. In addition, by using the conductive connecting material of the present invention, a connection terminal can be produced on an electrode of an electronic member by a convenient method.

BREIF DESCRIPTION OF THE DRAWINGS

[Figure 1] Figure 1 is a schematic plan view showing examples of a shape of a metal foil layer used with the present invention.
[Figure 2] Figure 2 is a cross-sectional view schematically showing one exemplary state of a substrate and a conductive connecting material after arranging the conductive connecting material between the terminal according to a method for connecting terminal of the present invention.
[Figure 3] Figure 3 is a cross-sectional view schematically showing one exemplary state of a substrate, a conductive region and an insulating region after heating, curing/solidifying the conductive connecting material arranged between the terminals according to a method for connecting terminals of the present invention.
[Figure 4] Figure 4 is a cross-sectional view schematically showing one exemplary state of a substrate and a conductive connecting material after arranging the conductive connecting material between the terminals according to a method for connecting terminals of the present invention.
[Figure 5] Figure 5 is a cross-sectional view schematically showing one exemplary state of a substrate and a conductive connecting material after arranging the conductive connecting material on an electrode provided on the substrate according to a method for producing a connection terminal of the present invention.
[Figure 6] Figure 6 is a cross-sectional view schematically showing one exemplary state of a substrate and a conductive connecting material after arranging the conductive connecting material on an electrode provided on the substrate according to a method for producing a connection terminal of the present invention.
[Figure 7] Figure 7 is a cross-sectional view schematically showing one exemplary state of a substrate, a conductive region and an insulating region after heating and curing/solidifying the conductive connecting material arranged on an electrode provided on the substrate according to a method for producing a connection terminal of the present invention.
[Figure 8] Figure 8 is a graph showing the results from measurements of ion viscosity and ion viscosity slope of a resin composition in Example 1 of the present invention.
[Figure 9] Figure 9 is a graph showing the results from measurements of ion viscosity and ion viscosity slope of a resin composition in Example 2 of the present invention.
[Figure 10] Figure 10 is a graph showing the results from measurements of ion viscosity and ion viscosity slope of a resin composition in Example 3 of the present invention.

EMBODIMENTS FOR CARRYING OUT THE INVENTION

Hereinafter, a conductive connecting material, a method for connecting terminals using the conductive connecting material, a method for producing the connection terminal and an electrical or electronic component electrically connected using the conductive connecting material according to the present invention will each be described in a specific manner.

1. Conductive connecting material

A conductive connecting material of the present invention comprises a resin composition and a metal foil (mental lyer) selected from a solder foil or a tin foil. It takers a form of a multi-layered body having a multilayer structure of a resin composition layer and a metal foil layer, where the resin composition layer and the metal foil layer may each be either a single layer or multiple layers. The multi-layered structure of the conductive connecting material is not particularly limited, and may be a two-layer structure of a resin composition layer and a metal foil layer (resin composition layer/metal foil layer), a three-layer structure or a multilayer structure having more layers, having a plurality of either or both of the resin composition layers and metal foil layers. When a plurality of resin composition layers or metal foil layers are used, the composition of each layer may be the same or different.

According to one embodiment of the present invention, in view of reducing the oxide layer on the metal foil surface with a compound having a fluxing function, the upper and lower layers of the metal foil layer are preferably resin composition layers. For example, a three-layered structure (resin composition layer/metal foil layer/resin composition layer) is favorable. In this case, the thickness of the resin composition layers on both sides of the metal foil layer may be the same or different. The thickness of the resin composition layer can appropriately be adjusted according to the thickness of the conductor of the terminal to be connected. For example, when a conductive connecting material whose resin composition layers on both sides of a metal foil layer have different thicknesses is used to produce a connection terminal, the thinner layer is preferably placed on the connection terminal side (electrode side). By making the distance between the metal foil and the connection terminal shorter, suppression of aggregation of solder or a tin component to the part of the connection terminal can be facilitated.

According to another embodiment of the present invention, for example, when a connection terminal is produced on an electronic member such as a semiconductor wafer, the conductive connecting material preferably has a resin composition layer on one side of a metal foil layer so that the metal foil can partially be exposed. When opposing connection terminals are connected using a conductive connecting material having a two-layer structure, the resin composition layer side may be brought into contact with the connection terminal or the metal foil layer side may be brought into contact with the connection terminal. When a conductive connecting material having a two-layer structure is used to connect connection terminals of opposing electronic members, the conductive connecting material is preferably adhered to each of the opposing electronic members, and then the electronic members associated with the conductive connecting materials are stuck together. Orientation of the conductive connecting material may appropriately selected according to the shape of the pattern of the metal foil.

Hereinafter, a resin composition and a metal foil used with the present invention will each be described.

(1) Resin composition

The present invention uses, as a resin composition that constitutes a resin composition layer, a resin composition whose minimum ion viscosity value is 4-9 when measured in accordance with ASTM standard E2039 by applying a frequency of 10000Hz at the melting point of a metal foil. The minimum ion viscosity value under the conditions for measuring the resin composition is preferably 4.5 or higher, more preferably 5 or higher and still more preferably 5.5 or higher, while preferably 8.5 or lower, more preferably 8.2 or lower and still more preferably 8 or lower. When the minimum ion viscosity value at the melting point of a metal foil lies within the above-mentioned range, aggregation of solder or tin between the terminals and thus formation of the conductive region can be facilitated while suppressing bleed of the resin composition upon packaging the electrical or electronic component. Besides, solder or tin remaining in an insulating region can be minimized to acquire highly-reliable insulation.

According to the present invention, a resin composition is defined to have the minimum ion viscosity value as mentioned above based on the knowledge that a resin composition shows favorable behavior to be used for a conductive connecting material when the minimum ion viscosity value of the resin composition determined by a dielectric analysis lies within the above-described range. Here, "dielectric analysis" means to analyze the curing behavior of the resin composition or the behavior of the resin composition in a melt state based on the dipole alignment and the change in the ion mobility utilizing the properties that the dipoles in the resin composition are oriented with the electric field, while the charged ions present as impurities in the resin composition migrate toward the electrode with opposite polarity.

According to the present invention, ion viscosity is measured in accordance with ASTM standard E2039 by applying a frequency of 10000Hz at the melting point of a metal foil. Specifically, if a resin composition is in a solid form at ambient temperature, it may be measured using NETZSCH DEA231/1 cure analyzer as a dielectric analyzer and NETZSCH MP235 Mini-Press as a press. If a resin composition is in a liquid form at ambient temperature, it may be measured using NETZSCH DEA231/1 cure analyzer as a dielectric analyzer, by applying a resin composition on a dielectric measurement sensor (NETZSCH, 036S-IDEX) and heating it in an oven.

By appropriately adjusting the weight-average molecular weight or the compounding amount of a polymer component (for example, a film-forming resin) in the resin composition, the minimum ion viscosity value can be adjusted

to fall within the above-mentioned, range. For example, the weight-average molecular weight of a film-forming resin used for a resin composition in a solid form is preferably adjusted to be 8,000-1,000,000, and the compounding amount is preferably adjusted to be 5-50% by weight with respect to the total weight of the resin composition.

According to one embodiment of the present invention, when a curable resin composition is used as a resin composition, it is preferable to use a curable resin composition whose maximum peak of the ion viscosity slope, when measured in accordance with ASTM standard E2039 by applying a frequency of 10000Hz at the melting point of a metal foil, appears 10 or more seconds from the initiation of the measurement.

The maximum peak of the ion viscosity slope indicates a region where the curing reaction of the curable resin composition becomes maximum. When this maximum peak appears after 10 or more seconds at the melting point of a metal foil, solder or tin can migrate sufficiently before curing of the curable resin composition progresses, and thus the solder or tin can be prevented from remaining in the insulating region. More preferably, the maximum peak of the ion viscosity slope appears after 15 seconds, still more preferably after 20 seconds and particularly preferably after 30 seconds. Furthermore, in terms of productivity, the slope appears preferably within 1000 seconds, more preferably within 800 seconds and still more preferably within 600 seconds from the initiation of the measurement.

According to the present invention, an ion viscosity slope can be determined from a differential value of ion viscosity.

Preferably, in order to adjust the maximum peak of the ion viscosity slope to fall in the above-described range, the types and the compounding amounts of the curing agent and the curing accelerator in the resin composition are appropriately adjusted. For example, when a phenol novolac resin is used as the curing agent, the compounding amount thereof is preferably made to be 1-50% by weight with respect to the total weight of the resin composition. Moreover, for example, when an imidazole compound is used as the curing accelerator, the compounding amount thereof is preferably made to be 0.001-1% by weight with respect to the total weight of the resin composition.

Furthermore, a resin composition used with the present invention is preferably one whose thermogravimetric weight loss is equal to or less than 5% by weight when measured by heating from 30˚C to the melting point of a metal foil at a temperature rising rate of 10˚C/min. The thermogravimetric weight loss is preferably equal to or less than 4.5% by weight, more preferably equal to or less than 4% by weight, and still more preferably equal to or less than 3% by weight. By limiting the thermogravimetric weight loss of the resin composition to be equal to or less than 5% by weight, generation of contamination and void due to outgassing can be suppressed and occurrence of crack in the package can be prevented.

According to the present invention, the thermogravimetric weight loss may be measured using a thermoscale (trade name: differential thermal/thermogravimetric simultaneous measurement instrument, model number "TG/DTA 6200" from Seiko Instruments).

In order to adjust the thermogravimetric weight loss to fall within the above-described range, the boiling point and the content of low-molecular-weight components (such as a diluent or a coupling agent used for adjusting viscosity) in the resin composition are preferably adjusted to lie in appropriate ranges. The boiling point of the low-molecular-weight components contained in the resin composition is preferably 120˚C or higher, more preferably 150˚C or higher and particularly preferably 180˚C or higher. Moreover, the content of the low-molecular-weight components is preferably 20% by weight or less, more preferably 10% by weight or less and still more preferably 5% by weight or less with respect to the total weight of the resin composition.

The resin composition used with the present invention may be either in a liquid form or a solid form at ambient temperature. Here, the phrase "a liquid form at ambient temperature," refers to a state where the composition does not have a definite shape at ambient temperature (25˚C). A paste form is also included in the liquid form.

According to the present invention, the resin composition may be either a curable resin composition or a thermoplastic resin composition. Examples of a curable resin composition used with the present invention include those that cure upon heating or irradiation with actinic ray. A thermosetting resin composition is favorable in terms of good mechanical properties such as coefficient of thermal expansion and elastic modulus after curing. A thermoplastic resin composition used with the present invention is not particularly limited as long as it has flexibility that allows molding by heating at a predetermined temperature.

(a) Curable resin composition

Other than a curable resin, a curable resin composition used with the present invention may also include, if necessary, a film-forming resin, a curing agent, a curing accelerator, a compound having a fluxing function, a silane coupling agent and the like.

(i) Curable resin

In general, a curable resin used with the present invention is not particularly limited as long as it can be used

as an adhesive component for producing a semiconductor device. Examples of the curable resin include an epoxy resin, a phenoxy resin, a silicon resin, an oxetane resin, a phenol resin, a (meth)acrylate resin, a polyester resin (unsaturated polyester resin), a diallyl phthalate resin, a maleimide resin, a polyimide resin (polyimide precursor resin) and a bismaleimide-triazine resin. In particular, a thermosetting resin containing at least one selected from the group consisting of an epoxy resin, a (meth)acrylate resin, a phenoxy resin, a polyester resin, a polyimide resin, a silicon resin, a maleimide resin, a bismaleimide-triazine resin is preferably used. Among them, an epoxy resin is preferably used in view that its curing and preserving properties are good, and that a cured product thereof has good thermal resistance, moisture resistance and chemical resistance. These curable resins may be used alone or two or more types thereof may be used in combination.

The content of the curable resin may appropriately be determined according to the form of the curable resin composition.

For example, if the curable resin composition is in a liquid form, the content of the curable resin with respect to the total weight of the curable resin composition is preferably 10% by weight or more, more preferably 15% by weight or more, still more preferably 20% by weight or more, still more preferably 25% by weight or more, yet still more preferably 30% by weight or more, and particularly preferably 35% by weight or more.

At the same time, the content of the curable resin is preferably less than 100% by weight, more preferably equal to or less than 95% by weight, still more preferably equal to or less than 90% by weight, still more preferably equal to or less than 75% by weight, yet still more preferably equal to or less than 65% by weight, and particularly preferably equal to or less than 55% by weight.

If the curable resin composition is in a solid form, the content of the curable resin with respect to the total weight of the curable resin composition is preferably 5% by weight or more, more preferably 10% by weight or more, still more preferably 15% by weight or more and particularly preferably 20% by weight or more. At the same time, the content of the curable resin is preferably 90% by weight or less, more preferably 85% by weight or less, still more preferably 80% by weight or less, still more preferably 75% by weight or less, yet still more preferably 65% by weight or less, and particularly preferably 55% by weight or less.

Sufficient electric connection strength and mechanical adhesive strength between the terminals can be ensured when the content of the curable resin is within the above-mentioned range.

According to the present invention, an epoxy resin that is either in a liquid form or a solid form at room temperature can be used. An epoxy resin that is in a liquid form at room temperature and an epoxy resin that is in a solid form at room temperature may be used in combination. When the curable resin composition is in a liquid form, an epoxy resin that is in a liquid form at room temperature is preferably used. When the curable resin composition is in a solid form, an epoxy resin that is either in a liquid form or a solid form may be used, where a film-forming resin is preferably used in combination as appropriate when an epoxy resin in a solid form is used.

Preferable examples of an epoxy resin that is in a liquid form at room temperature (25˚C) include a bisphenol-A epoxy resin and a bisphenol-F epoxy resin. A bisphenol-A epoxy resin and a bisphenol-F epoxy resin may also be used in combination.

The epoxy equivalent of the epoxy resin that is in a liquid form at room temperature is preferably 150-300 g/eq, more preferably 160-250 g/eq and particularly preferably 170-220 g/eq. If the epoxy equivalent is lower than the lower limit mentioned above, the shrinkage percentage of the cured product is likely to increase, which may result in warpage. On the other hand, if the epoxy equivalent exceeds the upper limit mentioned above, reactivity with a film-forming resin, particularly a polyimide resin, is likely to be reduced when such a film-forming resin is used in combination.

Examples of an epoxy resin that is in a solid form at room temperature (25˚C) include a bisphenol-A epoxy resin, a bisphenol-S epoxy resin, a phenol novolac epoxy resin, a cresol novolac epoxy resin, a glycidyl amine epoxy resin, a glycidyl ester epoxy resin, a trifunctional epoxy resin and a tetrafunctional epoxy resin. Among them, a solid trifunctional epoxy resin, a cresol novolac epoxy resin and the like are favorable. These epoxy resins may be used alone or two or more types thereof may be used in combination.

The epoxy equivalent of the epoxy resin that is in a solid form at room temperature is preferably 150-3000 g/eq, more preferably 160-2500 g/eq and particularly preferably 170-2000 g/eq.

A softening point of an epoxy resin that is in a solid form at room temperature is preferably 40-120˚C, more preferably 50-110˚C, and particularly preferably 60-100˚C. When the softening point lies within the above-mentioned range, tackiness can be suppressed and thus handling can be easier.

When an epoxy resin is used as a curable resin, the content thereof may appropriately be determined in accordance with the form of the curable resin composition.

For example, the content of the epoxy resin with respect to the total weight of the curable resin composition is preferably 10% by weight or more, more preferably 15% by weight or more, still more preferably 20% by weight or more, still more preferably 25% by weight or more, yet still more preferably 30% by weight or more and particularly preferably 35% by weight or more. At the same time, the content is preferably 90% by weight or less, more preferably 85% by weight or less, still more preferably 80% by weight or less, still more preferably 75% by weight or less, yet still more preferably

65% by weight or less and particularly preferably 55% by weight or less.
When the content of an epoxy resin lies within the above-described range, sufficient electric connection strength and mechanical adhesive strength between the terminals can be ensured.

(ii) Film-forming resin

When a curable resin composition in a solid form is used, the above-described curable resin and film-forming resin are preferably used in combination. The film-forming resin used with the present invention is not particularly limited as long as it is soluble in an organic solvent, and has a film-forming property by itself. Either a thermoplastic resin or a thermosetting resin may be used, or they may be used in combination. Specifically, examples of a film-forming resin include a (meth)acrylic resin, a phenoxy resin, a polyester resin (saturated polyester resin), a polyurethane resin, a polyimide resin, a polyamide-imide resin, a siloxane-modified polyimide resin, a polybutadiene resin, a polypropylene resin, a styrene-butadiene-styrene copolymer, a styrene-ethylene-butylene-styrene copolymer, a polyacetal resin, a polyvinyl butyral resin, a polyvinyl acetal resin, butyl rubber, chloroprene rubber, a polyamide resin, an acrylonitril-butadiene copolymer, an acrylonitril-butadiene-acrylic acid copolymer, an acrylonitril-butadiene-styrene copolymer, polyvinyl acetate and nylon. Among them, a (meth)acrylic resin, a phenoxy resin, a polyester resin and a polyimide resin are favorable. The film-forming resins may be used alone or two or more types thereof may be used in combination.
Herein, a "(meth)acrylic resin" refers to a polymer of a (meth)acrylic acid or a derivative thereof, or a copolymer of a (meth)acrylic acid or a derivative thereof with other monomer. A "(meth)acrylic acid" refers to "acrylic acid or methacrylic acid" or the like.
Examples of a (meth)acrylic resin used with the present invention include polyacrylic acid, polymethacrylic acid, polymethyl acrylate, polyethyl acrylate, polybutyl acrylate, polyester acrylate such as polyacrylic acid-2-ethylhexyl, polymethyl methacrylate, polyethyl methacrylate, polyester methacrylate such as polybutyl methacrylate, polyacrylonitril, polymethacrylonitrile, polyacrylamide, a butyl acrylate-ethyl acrylate-acrylonitril copolymer, an acrylonitril-butadiene copolymer, an acrylonitril-butadiene-acrylic acid copolymer, an acrylonitril-butadiene-styrene copolymer, an acrylonitril-styrene copolymer, a methyl methacrylate-styrene copolymer, a methyl methacrylate-acrylonitril copolymer, a methyl methacrylate-alpha-methylstyrene copolymer, a butyl acrylate-ethyl acrylate-acrylonitril-2-hydroxyethyl methacrylate-methacrylic acid copolymer, a butyl acrylate-ethyl acrylate-acrylonitril-2-hydroxyethyl methacrylate-acrylic acid copolymer, a butyl acrylate-acrylonitril-2-hydroxyethyl methacrylate copolymer, a butyl acrylate-acrylonitril-acrylic acid copolymer, a butyl acrylate-ethyl acrylate-acrylonitril copolymer and an ethyl acrylate-acrylonitril-N,N-dimethylacrylamide copolymer. Among them, a butyl acrylate-ethyl acrylate-acrylonitril copolymer and an ethyl acrylate-acrylonitril-N,N-dimethylacrylamide are favorable. These (meth)acrylic resins may be used alone or two or more types thereof may be used in combination.
Among these (meth)acrylic resins, a (meth)acrylic resin obtained by copolymerizing monomers having a functional group such as a nitrile group, an epoxy group, a hydroxyl group or a carboxyl group is preferable since it can enhance adhesion property to the adherend and compatibility with other resin component. In such a (meth)acrylic resin, the content of the monomer having the above-mentioned functional group is not particularly limited, but it is preferably 0.1-50 mol%, more preferably 0.5-45 mol%, and particularly preferably 1-40 mol% to the whole monomer (100 mol%) upon synthesis of the (meth)acrylic resin. When the content of the monomer having the above-mentioned functional group is less than the above-mentioned lower limit, enhancement of the adhesion property is likely to be insufficient, whereas when the content exceeds the upper limit, enhancement of workability is likely to be insufficient due to too strong adhesive power.
The backbone of the phenoxy resin used with the present invention is not particularly limited, but examples thereof preferably include those of a bisphenol-A type, a bisphenol-F type and a biphenyl type. A phenoxy resin with the saturated water absorption percentage of less than 1% is preferable since occurrence of foam formation, peeling or the like upon adhesion or soldering at a high temperature can be suppressed. The saturated water absorption percentage can be derived as follows: the phenoxy resin is fabricated into a 25 μm-thick film, which is dried under an atmosphere at 100°C for an hour (absolute dryness), and left in a constant temperature and humidity bath at 40°C under a 90% RH atmosphere; the change in the mass of the film is measured every 24 hours, and the mass obtained at the point of saturation of the mass change is used for the following formula.

Saturated water absorption percentage (%) = {(Mass at the point of saturation) - (Mass at the point of absolute dryness)}/(Mass at the point of absolute dryness) x 100

A polyimide resin used with the present invention is not particularly limited as long as it is a resin having an imide bond in the recurring unit. Examples include those obtained by reacting diamine with a dianhydride, and heating and cyclodehydrating the resulting polyamide acid.

Examples of a diamine include aromatic diamines such as 3,3'-dimethyl-4,4'diaminodiphenyl, 4,6-dimethyl-m-phenylenediamine, 2,5-dimethyl-p-phenylenediamine, and siloxanediamines such as 1,3-bis(3-aminopropyl)-1,1,3,3-tetramethyldisiloxane. The diamines may be used alone or two or more types thereof may be used in combination.

Furthermore, examples of the above-mentioned dianhydride include 3,3,4,4'-biphenyltetracarboxylic acid, pyromellitic dianhydride and 4,4'-oxydiphthalic dianhydride. The dianhydrides may be used alone or two or more types thereof may be used in combination.

The polyimide resin may be soluble or insoluble in a solvent, but it is preferably soluble in a solvent so that it can easily be made into a varnish upon mixing with other components, and can easily be handled. In particular, a siloxane-modified polyimide resin is preferably used in that it can be dissolved in various organic solvents.

A weight-average molecular weight of the film-forming resin used with the present invention is preferably 8,000-1,1,000,000, more preferably 8,500-950,000 and still more preferably 9,000-900,000. When the weight-average molecular weight of the film-forming resin lies in the above-described range, the film-forming property can be enhanced, and fluidity of the conductive connecting material prior to curing can be suppressed. The weight-average molecular weight of the film-forming resin can be measured by GPC (gel permeation chromatography).

According to the present invention, a commercially-available product may be used as such a film-forming resin. Moreover, the film-forming resin used may be blended with various types of additives such as a plasticizer, a stabilizer, an inorganic filler, an antistatic agent and a pigment to a degree that does not interfere with the effect of the present invention.

In a conductive connecting material used with the present invention, the content of the film-forming resin may appropriately be determined according to the form of the curable resin composition used.
For example, in the case of a curable resin composition in a solid form, the content of the film-forming resin to the total weight of the curable resin composition is preferably 5% by weight or more, more preferably 10% by weight or more and particularly preferably 15% by weight or more. At the same time, the content is preferably 50% by weight or less, more preferably 45% by weight or less and particularly preferably 40% by weight or less. When the content of the film-forming resin lies within the above-described range, the fluidity of the curable resin composition prior to melting can be suppressed and the conductive connecting material can be easily handled.

(iii) Curing agent

Examples of a curing agent used with the present invention include phenols, acid anhydrides and amine compounds. The curing agent may appropriately be selected according to the type of the curable resin. For example, when an epoxy resin is used as the curable resin, phenols are preferably used as the curing agent for their good reactivity with the epoxy resin, small change in dimension upon curing and their suitable properties (e.g., heat resistance, moisture resistance, etc.) after curing, and bi- or higher functional phenols are more preferable for superior properties of the curable resin after curing.
These curing agents may be used alone or two or more types thereof may be used in combination.

Examples of phenols include bisphenol-A, tetramethyl bisphenol-A, diallyl bisphenol-A, biphenol, bisphenol-F, diallyl bisphenol-F, trisphenol, tetrakisphenol, a phenol novolac resin and a cresol novolac resin. Among them, a phenol novolac resin and a cresol novolac resin are favorable due to their good reactivity with the epoxy resin and superior properties after curing.

The content of the curing agent may appropriately be selected according to the types of the curable resin and the curing agent used, as well as the type and the used amount of a functional group if the later-described compound having the fluxing function has the functional group that serves as a curing agent.
For example, when an epoxy resin is used as the curable resin, the content of the curing agent to the total weight of the curable resin composition is preferably 0.1-50% by weight, more preferably 0.2-40% by weight and particularly preferably 0.5-30% by weight. When the content of the curing agent lies within the above-described range, electric connection strength and mechanical adhesive strength between the terminals can be ensured.

According to the present invention, a phenol novolac resin is preferably used as the curing agent. For example, when a phenol novolac resin is used, the content thereof to the total weight of the curable resin composition is preferably 1% by weight or more, more preferably 3% by weight or more and particularly preferably 5% by weight or more, while preferably 50% by weight or less, more preferably 40% by weight or less and particularly preferably 30% by weight or less. When the content of the phenol novolac resin becomes less than the above-mentioned lower limit, curing of the curable resin is likely to be insufficient. On the other hand, when the content exceeds the above-mentioned upper limit, unreacted phenol novolac resin is likely to remain and cause ion migration.

When an epoxy resin is used as the curable resin, the content of the phenol novolac resin may be defined by an equivalent ratio to the epoxy resin. For example, the equivalent ratio of the phenol novolac resin to the epoxy resin is preferably 0.5-1.2, more preferably 0.6-1.1, and particularly preferably 0.7-0.98. When the equivalent ratio is lower than the above-mentioned lower limit, heat resistance and moisture resistance after the curing of the epoxy resin is likely

to be reduced. On the other hand, when the equivalent ratio exceeds the above-described upper limit, unreacted phenol novolac resin is likely to remain and cause ion migration.

(iv) Curing accelerator

Examples of a curing accelerator used with the present invention include imidazole compounds such as imidazole, 2-methylimidazole, 2-undecylimidazole, 2-heptadecylimidazole, 1,2-dimethylimidazole, 2-ethyl-4-methylimidazole, 2-phenylimidazole, 2-phenyl-4-methylimidazole, 1-benzyl-2-phenylimidazole, 1-benzyl-2-methylimidazole, 1-cyanoethyl-2-methylimidazole, 1-cyanoethyl-2-ethyl-4-methylimidazole, 1-cyanoethyl-2-undecylimidazole, 1-cyanoethyl-2-phenylimidazole, 1-cyanoethyl-2-undecylimidazoliumtnmellitate, 1-cyanoethyl-2-phenylimidazoliumtrimellitate, 2,4-diamino-6-[2'-methylimidazolyl(1')]-ethyl-s-triazine, 2,4-diamina-6-[2'-unclecylimidazolyl (1')]-ethyl-s-triazine, 2,4-diamino-6-[2'-ethyl-4-methylimidazolyl (1')]-ethyl-s-triazine, an isocyanuric acid adduct of 2,4-diamino-6-[2'-methylimidazolyl (1')]-ethyl-s-triazine, an isocyanuric acid adduct of 2-phenylimidazole, an isocyanuric acid adduct of 2-methylimidazole, 2-phenyl-4,5-dihydroxydimethylimidazole and 2-phenyl-4-methyl-5-hydroxymethylimidazole.

Among these curing accelerators, an imidazole compound having a melting point of 150°C or higher is preferable in terms that solder or tin can migrate to the surface of the terminal before completion of the curing of the curable resin composition. Examples of an imidazole compound having a melting point of 150°C or higher include 2-phenylimidazole, 2-phenyl-4-methylimidazole, 1-cyanoethyl-2-phenylimidazole, 2,4-diamino-6-[2'methylimidazolyl (1')]-ethyl-s-triazine, 2,4-diamino-6-[2'-undecylimidazolyl (1')]-ethyl-s-triazine, 2,4-diamino-6-[2'-ethyl-4-methylimidazolyl (1')]-ethyl-s-triazine, an isocyanuric acid adduct of 2,4-diamino-6-[2'-methylimidazolyl (1')]-ethyl-s-triazine, an isocyanuric acid adduct of 2-phenylimidazole, 2-phenyl-4,5-dihydroxydimethylimidazole and 2-phenyl-4-methyl-5-hydroxymethylimidazole. The curing accelerators may be used alone or two or more types thereof may be used in combination.

The content of the curing accelerator may appropriately be determined according to the type of the curing accelerator used.
For example, when an imidazole compound is used, the content of the imidazole compound to the total weight of the curable resin composition is preferably 0.001% by weight or more, more preferably 0.003% by weight or more and particularly preferably 0.005% by weight or more. At the same time, the content is preferably 1.0% by weight or less, more preferably 0.7% by weight or less and particularly preferably 0.5% by weight or less. When the content of the imidazole compound is less than the lower limit, action as a curing accelerator may not be sufficiently effective such that the curing of the curable resin composition may come short. On the other hand, when the content of the imidazole compound exceed the above-described upper limit, solder or tin may not sufficiently migrate to the surface of the terminal before completion of the curing of the curable resin composition such that the solder or tin may remain in the insulating regions causing inadequate insulation. Moreover, preservation stability of the conductive connecting material may be deteriorated.

(v) Compound having fluxing function

A compound having the fluxing function used with the present invention has an effect of reducing a metal-oxide layer such as an oxide layer on a surface of a terminal or a metal foil. For example, a compound having the fluxing function is preferably a compound having a phenolic hydroxyl group and/or a carboxyl group. Examples of a compound having a phenolic hydroxyl group include monomers containing a phenolic hydroxyl group such as phenol, o-cresol, 2,6-xylenol, p-cresol, m-cresol, o-ethylphenol, 2,4-xylenol, 2,5-xylenol, m-ethylphenol, 2,3-xylenol, meditol, 3,5-xylenol, p-tertbutylphenol, catechol, p-tert-amylphenol, resorcinol, p-octylphenol, p-phenylphenol, bisphenol-F, bisphenol-AF, biphenol, diallyl bisphenol-F, diallyl bisphenol-A, trisphenol, tetrakisphenol, and resins containing a phenolic hydroxyl group such as a phenol novolac resin, an o-cresol novolac resin, a bisphenol-F novolac resin and a bisphenol-A novolac resin.

Examples of a compound having a carboxyl group include an aliphatic acid anhydride, an alicyclic acid anhydride, an aromatic acid anhydride, aliphatic carboxylic acid and aromatic carboxylic acid. Examples of the aliphatic acid anhydride include succinic anhydride, polyadipic anhydride, polyazelaic anhydride and polysebacic anhydride. Examples of the alicyclic acid anhydride include methyltetrahydrophtalic anhydride, methylhexahydrophtalic anhydride, methyl himic anhydride, hexahydrophtalic anhydride, tetrahydrophtalic anhydride, trialkyltetrahydrophtalic anhydride and methyl cyclohexanedicarboxylic anhydride. Examples of the aromatic acid anhydride include phtalic anhydride, trimellitic anhydride, pyromellitic dianhydride, benzophenone tetracarboxylic anhydride, ethylene glycol bis-trimellitate and glycerol tris-trimellitate.

Examples of the aliphatic carboxylic acid include formic acid, acetate acid, propionic acid, butyric acid, valeric acid, pivalic acid, caproic acid, caprylic acid, lauric acid, myristic acid, palmitic acid, stearic acid, acrylic acid, methacrylic acid, crotonic acid, oleic acid, fumaric acid, maleic acid, oxalic acid, malonic acid, succinic acid, glutaric acid, adipic acid, sebacic acid, dodecanedioic acid and pimelic acid. Among them, an aliphatic carboxylic acid represented by the

following Formula (1):

$$HOOC\text{-}(CH_2)_n\text{-}COOH \qquad (1)$$

where, n is an integer of 1-20 is preferable, and adipic acid, sebacic acid and dodecanedioic acid are more preferable.

The structure of the aromatic carboxylic acid is not particularly limited, but it is preferably a compound represented by the following Formula (2) or (3).

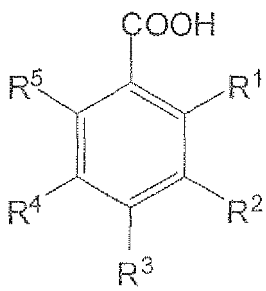

(2)

where, $R^1$-$R^5$ are each independently a monovalent organic group, and at least one of $R^1$-$R^5$ is a hydroxyl group,

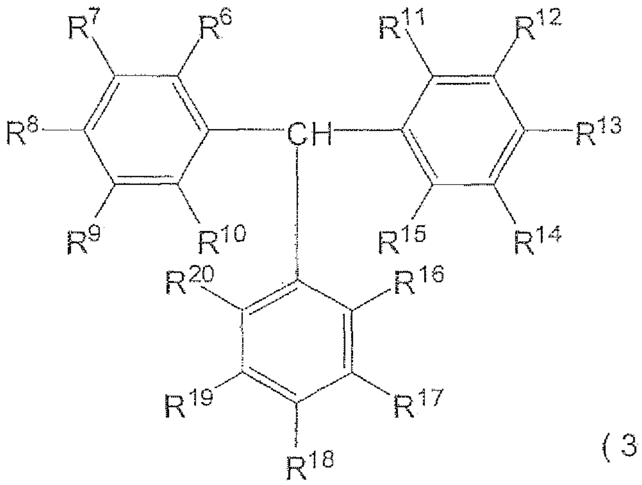

(3)

where, $R^6$-$R^{20}$ is each independently a monovalent organic group, and at least one of $R^6$-$R^{20}$ is a hydroxyl group or a carboxyl group.

Examples of aromatic carboxylic acid include benzoic acid derivatives such as benzoic acid, phthalic acid, isophthalic acid, terephthalic acid, hemimellitic acid, trimellitic acid, trimesic acid, mellophanic acid, prehnitic acid, pyromellitic acid, mellitic acid, xylyl acid, hemellitic acid, mesitylenic acid, prehnitylic acid, toluic acid, cinnamic acid, salicylic acid, 2,3-dihydroxybenzoic acid, 2,4-dihydroxybenzoic acid, gentisic acid (2,5-dihydroxybenzoic acid), 2,6-dihydroxybenzoic acid, 3,5-dihydroxybenzoic acid, gallic acid (3,4,5-trihydroxybenzoic acid), and naphthoic acid derivatives such as 4-dihydroxy-2-naphthoic acid, 3,5-dihydroxy-2-naphthoic acid and 3,5-2-dihydroxy-2-naphthoic acid; phenolphthalin; and diphenolic acid.

Among them, a compound that not only has a fluxing function but also serves as a curing agent for a curable resin is favorable for the present invention. Specifically, a compound having the fluxing function used with the present invention is preferably a compound that reduces an oxide layer on a surface of a metal such as a metal foil and a terminal, and that has a functional group that can react with a curable resin. Such a functional group may appropriately be selected according to the type of the curable resin. For example, when an epoxy resin is used as the curable resin, the functional group is preferably a functional group that can react with an epoxy group such as a carboxyl group, a hydroxyl group and an amino group. Since the compound having the fluxing function also serves as a curing agent, an oxide layer on a surface of a metal such as a metal foil and a terminal can be reduced, by which the wettability of the metal surface is increased and formation of a conductive region is facilitated, and it is added to the curable resin after formation of the conductive region to increase elastic modulus or Tg of the resin. In addition, since the compound having the fluxing

function serves as a curing agent, flux washing becomes unnecessary, and thus advantageous in that occurrence of ion migration due to a residual flux component can be suppressed.

Such a compound having the fluxing function preferably have at least one carboxyl group. For example, when an epoxy resin is used as a curable resin, the compound may be aliphatic dicarboxylic acid or a compound having a carboxyl group and a phenolic hydroxyl group.

A preferable example of aliphatic dicarboxylic acid includes a compound in which a aliphatic hydrocarbon group is bound with two carboxyl groups. The aliphatic hydrocarbon group may be a saturated or unsaturated acyclic group or a saturated or unsaturated cyclic group. In addition, when the aliphatic hydrocarbon group is an acyclic group, it may be either linear or branched.

Such an aliphatic dicarboxylic acid may preferably be a compound represented by Formula (1) above where n is an integer of 1-20. When "n" in Formula (1) is within the above-mentioned range, balance of the flux activity, outgassing upon adhesion, elastic modulus after curing of the conductive connecting material and glass-transition temperature becomes favorable. In particular, n is preferably equal to or higher than 3 since increase in the elastic modulus after curing of the conductive connecting material can be suppressed while the adhesion property with an adherend is enhanced. Moreover, n is preferably equal to or lower than 10 since decrease in the elastic modulus can be suppressed and connection reliability can be further enhanced.

Examples of an aliphatic dicarboxylic acid represented by Formula (1) above include glutaric acid, adipic acid, pimelic acid, suberic acid, azelaic acid, sebacic acid, undecanedioic acid, dodecanedioic acid, tridecanedioic acid, tetradecanedioic acid, pentadecanedioic acid, octadecanedioic acid, nonadecanedioic acid and eicosanedioic acid. Among them, adipic acid, suberic acid, sebacic acid and dodencanedioic acid are preferable and sebacic acid is particularly preferable.

Examples of the compound having the carboxyl group and the phenolic hydroxyl group include benzoic acid derivatives such as salicylic acid, 2,3-dihydroxybenzoic acid, 2,4-dihydroxybenzoic acid, gentisic acid (2,5-dihydroxybenzoic acid), 2,6-dihydroxybenzoic acid, 3,4-dihydroxybenzoic acid and gallic acid (3,4,5-trihydroxybenzoic acid); naphthoic acid derivatives such as 1,4-dihydroxy-2-naphthoic acid and 3,5-dihydroxy-2-naphthoic acid; phenolphthalin; and diphenolic acid. Among them, phenolphthalin, gentisic acid, 2,4-dihydroxybenzoic acid and 2,6-dihydroxybenzoic acid are favorable, and phenolphthalin and gentisic acid are particularly favorable.

The compounds having the fluxing function may be used alone or two or more types thereof may be used in combination. Since any of the compounds easily absorb moisture which may cause void generation, the compound having the fluxing function is preferably dried in advance before use.

The content of the compound having the fluxing function can appropriately be selected according to the form of the resin composition used.

For example, when the resin composition is in a liquid form, the content of the compound having the fluxing function to the total weight of the curable resin composition is preferably 1% by weight or more, more preferably 2% by weight or more and particularly preferably 3% by weight or more. At the same time, the content is preferably 50% by weight or less, more preferably 40% by weight or less, still more preferably 30% by weight or less and particularly preferably 25% by weight or less.

In the case of a resin composition in a solid form, the content of the compounds having the fluxing function to the total weight of the curable resin composition is preferably 1% by weight or more, more preferably 2% by weight or more and particularly preferably 3% by weight or more. At the same time, the content is preferably 50% by weight or less, more preferably 40% by weight or less, still more preferably 30% by weight or less and particularly preferably 25% by weight or less.

When the content of the compound having the fluxing function lies within the above-mentioned range, an oxide layer on a surface of a metal foil or a terminal can be removed to an extent that allows electric connection. Furthermore, when the resin composition is a curable resin, it can efficiently be added to the resin upon curing and increase the elastic modulus or Tg of the resin. In addition, occurrence of ion migration caused by unreacted compound having the fluxing function can be suppressed.

(vi) Silane coupling agent

Examples of a silane coupling agent used with the present invention include an epoxy silane coupling agent and an aromatic-containing amino silane coupling agent. Addition of a silane coupling agent can enhance the adhesion property between the connected member and the conductive connecting material. The silane coupling agents may be used alone or two or more types thereof may be used in combination.

The content of the silane coupling agent may appropriately be selected according to the types of the connected member, the curable resin and the like. For example, the content of the silane coupling agent to the total weight of the curable resin composition is preferably 0.01% by weight or more, more preferably 0.05% by weight or more and particularly preferably 0.1% by weight or more while preferably 2% by weight or less, more preferably 1.5% by weight or less and

particularly preferably 1% by weight or less.

The curable resin composition used with the present invention may be blended, to an extent that does not interfere with the effect of the present invention, with a plasticizer, a stabilizer, a tackifier, a lubricant, an antioxidant, an inorganic filler, a filler, an antistatic agent, a pigment and the like.

According to the present invention, the curable resin composition may be prepared by mixing and dispersing each of the above-mentioned components. A method for mixing or dispersing each of the components is not particularly limited and they may be mixed or dispersed according to a conventional known method.

According to the present invention, each of the above-described components may be mixed in a solvent or without a solvent to prepare a curable resin composition in a liquid form. The solvent used for this is not particularly limited as long as it is inactive to each component, examples being ketones such as acetone, methyl ethyl ketone (MEK), methyl isobutyl ketone (MIBK), diisobutyl ketone (DIBK), cyclohexanone and diacetone alcohol (DAA); aromatic hydrocarbons such as benzene, xylene and toluene, alcohols such as methyl alcohol, ethyl alcohol, isopropyl alcohol and n-butyl alcohol, cellosolves such as methylcellosolve, ethylcellosolve, butylcellosolve, methylcellosolve acetate and ethylcellosolve acetate, N-methyl-2-pyrrolidone (NMP), tetrahydrofuran (THF), dimethylformamide (DMF), dibasic ester (DBE), 3-ethyl ethoxypropionate (EEP) and dimethyl carbonate (DMC). Furthermore, the solvent is preferably used in an amount that gives a solid content concentration of the components mixed in the solvent of 10-60% by weight.

(b) Thermoplastic resin composition

According to the present invention, a thermoplastic resin composition may also be used as a resin composition. The thermoplastic resin composition used with the present invention may contain, other than a thermoplastic resin, if necessary, a compound having a fluxing function and a silane coupling agent.

(i) Thermoplastic resin

Examples of the thermoplastic resin used with the present invention include vinyl acetate series, a polyvinyl alcohol resin, a polyvinyl butyral resin, a vinyl chloride resin, a (meth)acrylic resin, a phenoxy resin, a polyester resin, a polyimide resin, a polyamide-imide resin, a siloxane-modified polyimide resin, a polybutadiene resin, an acrylic resin, a styrene resin, a polyethylene resin, a polypropylene resin, a polyamide resin, a cellulose resin, an isobutylene resin, a vinyl ether resin, a liquid crystalline polymer resin, a polyphenylene sulfide resin, a polyphenylene ether resin, a polyethersulphone resin, a polyetherimide resin, a polyetherether ketone resin, a polyurethane resin, a styrene-butadiene-styrene copolymer, a styrene-ethylene-butylene-styrene copolymer, a polyacetal resin, a polyvinyl butyral resin, a polyvinyl acetal resin, butyl rubber, chloroprene rubber, an acrylonitril-butadiene copolymer, an acrylonitril-butadiene-acrylic acid copolymer, an acrylonitril-butadiene-styrene copolymer, and polyvinyl acetate. The thermoplastic resin may be a single polymer or a copolymer of two or more types of the above-mentioned thermoplastic resin.

The softening point of the thermoplastic resin is not particularly limited but it is preferably lower by 10˚C or more, more preferably lower by 20˚C or more and particularly preferably lower by 30˚C or more than the melting point of a metal foil making the conductive connecting material.

The decomposition temperature of the thermoplastic resin is not particularly limited, but it is preferably higher by 10˚C or more, particularly preferably higher by 20˚C or more and more preferably higher by 30˚C or more than the melting point of a metal foil making the conductive connecting material.

The content of the thermoplastic resin may appropriately be determined according to the form of the thermoplastic resin composition used.

For example, when the thermoplastic resin composition is in a liquid form, the content of the thermoplastic resin to the total weight of the thermoplastic resin composition is preferably 10% by weight or more, more preferably 15% by weight or more, still more preferably 20% by weight or more, still more preferably 25% by weight or more, yet still more preferably 30% by weight or more and particularly preferably 35% by weight or more. At the same time, the content is preferably 100% by weight or less, more preferably 95% by weight or less, still more preferably 90% by weight or less, still more preferably 75% by weight or less, yet still more preferably 65% by weight or less and particularly preferably 55% by weight or less.

When the thermoplastic resin composition is in a solid form, the content of the thermoplastic resin to the total weight of the thermoplastic resin composition is preferably 5% by weight or more, more preferably 10% by weight or more, still more preferably 15% by weight or more and particularly preferably 20% by weight or more. At the same time, the content is preferably 90% by weight or less, more preferably 85% by weight or less, still more preferably 80% by weight or less, still more preferably 75% by weight or less, yet still more preferably 65% by weight or less and particularly preferably 55% by weight or less.

When the content of the thermoplastic resin lies within the above-mentioned range, sufficient electric connection strength and mechanical adhesive strength between the terminals can be ensured.

(ii) Other additives

A compound having a fluxing function, a silane coupling agent and other additives used in the thermoplastic resin composition of the present invention may be the same as those described in "(a) Curable resin composition" above. The content of each component, preferable compounds and methods for preparing the same are also the same as those described in "Curable resin composition" above.

According to the present invention, a curable resin composition is preferably used as a resin composition. Among them, those containing 10-90% by weight of an epoxy resin, 0.1-50% by weight of a curing agent, 5-50% by weight of a film-forming resin and 1-50% by weight of a compound having a fluxing function to the total weight of the resin composition are favorable. In addition, those containing 20-80% by weight of an epoxy resin, 0.2-40% by weight of a curing agent, 10-45% by weight of a film-forming resin and 2-40% by weight of a compound having a fluxing function to the total weight of the resin composition are further favorable. Moreover, those containing 35-55% by weight of an epoxy resin, 0.5-30% by weight of a curing agent, 15-40% by weight of a film-forming resin and 3-25% by weight of a compound having a fluxing function to the total weight of the resin composition are particularly favorable.

The content of the resin composition in the conductive connecting material of the present invention may appropriately be determined according to the form of the resin composition.

For example, when the resin composition is in a liquid form, the content of the resin composition to the total weight of the conductive connecting material is preferably 10% by weight or more, more preferably 20% by weight or more and particularly preferably 25% by weight or more. At the same time, the content is preferably 95% by weight or less, more preferably 80% by weight or less and particularly preferably 75% by weight or less.

When the resin composition is in a solid form, the content of the resin composition to the total weight of the conductive connecting material is preferably 10% by weight or more, more preferably 15% by weight or more and particularly preferably 20% by weight or more. At the same time, the content is preferably 95% by weight or less, more preferably 80% by weight or less and particularly preferably 75% by weight or less.

A thickness of each resin composition layer of the conductive connecting material of the present invention is not particularly limited but it is preferably 1 μm or more, more preferably 3 μm or more and particularly preferably 5 μm or more. At the same time, the thickness of the resin composition layer is preferably 200 μm or less, more preferably 150 μm or less and particularly preferably 100 μm or less. When the thickness of the resin composition layer lies within the above-mentioned range, the space between the adjacent terminals can adequately be filled with the resin composition, and thus sufficient mechanical adhesive strength and sufficient electric connection between the opposing terminals can be ensured after curing/solidification of the resin composition, thereby allowing production of the connection terminals.

When the conductive connecting material of the present invention contains a plurality of the resin composition layers, the composition of each resin composition layer may be the same or different according to the types and formulations of the resin components used. The properties of the resin composition layer such as melting viscosity and the softening temperature may also be the same or different. For example, a resin composition layer in a liquid form and a resin composition layer in a solid form may be used in combination.

(2) Metal foil (Metal layer)

According to the present invention, a metal foil layer is a layer composed of a metal foil selected from a solder foil or a tin foil. A metal foil layer may be formed on at least a part of the resin composition layer or the whole area of the resin composition layer when seen in a planar view.

The shape of the metal foil layer is not particularly limited, and it may be formed into a repeated pattern of a certain shape, or into irregular shapes. Regular and irregular shapes may be mixed together. Figure 1 is a schematic plan view showing examples of the shapes of the metal foil layers. Various shapes of metal foil layers 110 are disposed on resin composition layers 120. Examples of the shape of the metal foil layer include, as shown in Figure 1, a punched-out dot pattern (a), a stripe pattern (b), a polka-dot pattern (c), a rectangular pattern (d), a checkered pattern (e), a frame pattern (f), a lattice pattern (g) and a multi-frame pattern (h). These shapes are merely a part of examples, and they may be combined together or their shapes may be modified according to the purpose or application.

According to one embodiment of the present invention, when a full grid adherend in which the electrodes to be connected are arranged all over the connecting surface of the adherend is to be connected, a sheet-like metal foil is preferably disposed on the whole surface of the resin composition.

When a peripheral-type adherend in which the electrodes to be connected are arranged on the peripheral area of the connecting surface of the adherend, a metal foil having a repeated pattern is preferably formed on at least part of the resin composition in terms of effective use of the metal foil and prevention of the metal foil to remain between the adjacent electrodes. In this case, the shape of the metal foil may appropriately be selected according to the pitch or form of the electrodes.

A metal foil used with the present invention is not particularly limited, but it is preferably an alloy of at least two

or more types of metals selected from the group consisting of tin (Sn), lead (Pb), silver (Ag), bismuth (Bi), indium (In), zinc (Zn), nickel (Ni), antimony (Sb), iron (Fe), aluminum (Al), gold (Au), germanium (Ge) and copper (Cu), or tin alone.

Among them, a metal foil is more preferably a solder foil of an alloy containing Sn such as an alloy of Sn-Pb, or a lead-free solder of an alloy of Sn-Bi, an alloy of Sn-Ag-Cu, an alloy of Sn-In or an alloy of Sn-Ag considering the melting temperature and the mechanical properties. When an alloy of Sn-Pb is used, the content rate of tin is preferably 30% by weight or more and less than 100% by weight, more preferably 35% by weight or more and less than 100% by weight, and preferably 40% by weight or more and less than 100% by weight. In the case of a lead-free solder, the content rate of tin is preferably 15% by weight or more and less than 100% by weight, more preferably 20% by weight or more and less than 100% by weight and particularly preferably 25% by weight or more and less than 100% by weight. For example, an alloy of Sn-Pb may preferably be Sn63-Pb (melting point: 183°C), and a lead-free solder may preferably be Sn-3.0Ag-0.5Cu (melting point: 217°C), Sn-3.5Ag (melting point: 221°C), Sn-58Bi (melting point: 139°C), Sn-9.0Zn (melting point: 199°C), Sn-3.5Ag-0.5Bi-3.0In (melting point: 193°C) and Au-20Sn (melting point: 280°C).

A metal foil may appropriately be selected according to the heat resistance of the electronic members or the semi-conductor device to be connected. For example, for connection between the terminals in a semi-conductor device, a metal foil having the melting point of 330°C or lower (more preferably 300°C or lower, particularly preferably 280°C or lower and more preferably 260°C or lower) is preferably used in order to prevent members of a semi-conductor device from being damaged due to heat history. Furthermore, in order to ensure heat resistance of the semi-conductor device after the terminal connection, a metal foil having the melting point at 100°C or higher (more preferably 110°C or higher and particularly preferably 120°C or higher) is preferably used. Here, the melting point of a metal foil can be measured with a differential scanning calorimeter (DSC).

The thickness of a metal foil may appropriately be selected according to the gap between the opposing terminals, distance of between adjacent terminals that are spaced apart, and the like. For example, in the case of connecting the connection terminals such as of a semiconductor chip, a substrate and a semiconductor wafer in a semi-conductor device, the thickness of the metal foil is preferably 0.5 $\mu$m or more, more preferably 3 $\mu$m or more and particularly preferably 5 $\mu$m or more, while preferably 100 $\mu$m or less, more preferably 50 $\mu$m or less and particularly preferably 20 $\mu$m or less. When the thickness of the metal foil is less than the above-mentioned lower limit, an unconnected terminal tend to increase due to lack of solder or tin. On the other hand, when the thickness exceeds the above-mentioned upper limit, bridge may occur between the adjacent terminals due to excess solder or tin, and thus likely to cause a short-circuit.

A method for producing a metal foil may be, for example, a method that produces the metal foil from a mass such as an ingot mass by rolling, or a method that forms a metal foil layer by direct evaporation, sputtering, plating or the like on a resin composition layer. A method for producing a metal foil having a repeated pattern may be, for example, a method in which a metal foil is punched out into a predetermined pattern, a method in which a predetermined pattern is formed by etching, and a method which forms a pattern by evaporation, sputtering, plating or the like using a shielding plate or mask.

The content of the metal foil to the total weight of the conductive connecting material is preferably 5% by weight or more, more preferably 20% by weight or more and particularly preferably 30% by weight or more. At the same time, the content is preferably less than 100% by weight, more preferably 80% by weight or less and particularly preferably 70% by weight or less. When the content of the metal foil is less than the above-mentioned lower limit, unconnected terminals tend to increase due to lack of solder or tin. On the other hand, when the content of the metal foil exceeds the above-mentioned upper limit, bridge is likely to occur between adjacent terminals due to excess solder or tin.

Alternatively, the content of the metal foil may be defined by its volume ratio to the conductive connecting material. For example, the content of the metal foil is preferably 1% by volume or more, more preferably 5% by volume or more and particularly preferably 10% by volume or more with respect to the conductive connecting material.
At the same time, the content is preferably 90% by volume or less, more preferably 80% by volume or less and particularly preferably 70% by volume or less. When the content of the metal foil is less than the above-mentioned lower limit, unconnected terminals tend to increase due to lack of solder or tin. On the other hand, when the content of the metal foil exceeds the above-mentioned upper limit, bridge is likely to occur between adjacent terminals due to excess solder or tin.

According to the present invention, the form of the conductive connecting material may appropriately be selected according to the form of the resin composition.
For example, when the resin composition is in a liquid form, a conductive connecting material can be provided: as a metal foil having the resin composition applied on both sides; or by applying the resin composition to a peelable base material such as a polyester sheet, which is dried at a predetermined temperature for the purpose of half-curing (B-stage curing) and film-forming, and then the metal foils are layered together to make a film. When the resin composition is in a solid form, a varnish of the resin composition dissolved in an organic solvent is applied on a peelable base material such as a polyester sheet and dried at a predetermined temperature. Then, the metal foils are formed into a film by layering the metal foils together or by employing a technique such as evaporation, thereby providing a conductive connecting material.

The conductive connecting material of the present invention and a metal foil used therefor may be embossed in order to enhance contact with the terminals.

The thickness of the conductive connecting material of the present invention is not particularly limited, but preferably 1 μm or more, more preferably 3 μm or more and particularly preferably 5 μm or more, while preferably 200 μm or less, more preferably 15 μm or less and particularly preferably 100 μm or less. When the thickness of the conductive connecting material is within the above-mentioned range, the gap between the adjacent terminals can adequately be filled in with the resin composition. Moreover, mechanical adhesive strength and electric connection between the terminals after curing or solidification of the resin component can be ensured to be sufficient. In addition, a connection terminal can be produced according to the purpose or application.

Hereinafter, a method for producing a conductive connecting material will be described.
When a resin composition used with the present invention is in a liquid form at 25˚C, for example, a metal foil is immersed in a resin composition in a liquid form to apply the resin composition in the liquid form to both sides of the metal foil, thereby producing a conductive connecting material of the present invention. When the thickness of the resin composition needs to be controlled, the conductive connecting material may be produced by a method in which the metal foil immersed in the resin composition in the liquid form is passed through bar coaters having certain gaps or by a method in which the resin composition in the liquid form is sprayed with a spray coater or the like.

When a resin composition used with the present invention is in a film form at 25˚C, a conductive connecting material may be produced, for example, as follows. First, a varnish of a resin composition dissolved in an organic solvent is applied to a peelable base material such as a polyester sheet and dried at a predetermined temperature to form a resin composition in a film form. Then, two resin composition films formed on the peelable base materials are prepared to sandwich a metal foil, which are then laminated by heat rolling, thereby producing a three-layered conductive connecting material consisting of resin composition/metal foil/resin composition where the resin compositions are arranged above and beneath the metal foil. Alternatively, according to the above-described lamination method, a two-layered conductive connecting material consisting of resin composition/metal foil can also be produced by arranging the resin composition on one side of the metal foil.

When a rolled metal foil is used, the metal foil is used as a base material, where the above-described film-type resin composition is laminated on both sides or one side of the metal foil by heat rolling, thereby obtaining a conductive connecting material in a roll. Furthermore, when a rolled metal foil is used, a varnish-type resin composition may directly be applied to both sides or one side of the metal foil while volatizing the solvent, thereby producing a conductive connecting material in a roll.

When a patterned metal foil is used to produce a conductive connecting material, the metal foil is arranged on a peelable base material, then the metal foil is half-cut with a die cut mold from the metal foil side. The excessive metal foil is removed to produce a patterned metal foil, on which the above-described resin composition in the film form can be laminated by heat rolling. When a resin composition is to be provided on both sides of the patterned metal foil, the above-described peelable base material is peeled off, and the film-type resin composition is additionally laminated on the metal foil on the side opposite from the side having the resin composition.
The method for producing a conductive connecting material is not limited to the above-described method. A method for producing a conductive connecting material may appropriately be selected by those skilled in the art according to purpose and application.

## 2. Method for connecting terminals

Hereinafter, a method for connecting terminals according to the present invention will be described.
A connection method of the present invention comprises the method for connecting terminals using the above-described conductive connecting material, where the method comprises the steps of: arranging a conductive connecting material between opposing terminals; heating the conductive connecting material; and curing/solidifying the resin composition. The connection method of the present invention may be used, for example, for connecting terminals formed on a semiconductor wafer, a semiconductor chip, a rigid substrate, a flexible substrate, and other electrical and electronic components.

The connection method of the present invention slightly varies between the case where the resin composition of the conductive connecting material is a curable resin composition and the case where it is a thermoplastic resin composition. Hereinafter, a first embodiment refers to a case where the resin composition of the conductive connecting material is a curable resin composition while a second embodiment refers to a case where the resin composition is a thermoplastic resin composition. Each of the embodiments will be described.

### (1) First embodiment

A method for connecting terminals according to the first embodiment of the present invention comprises the

steps of: arranging a conductive connecting material including the above-described curable resin composition and a metal foil between opposing terminals; heating the conductive connecting material at a temperature that is equal to or higher than the melting point of the metal foil and that does not complete curing of the curable resin composition; and curing the curable resin composition.

According to this connection method, heat-melted solder or tin can selectively be aggregated between the terminals to form a conductive region and a curable resin composition can be formed as an insulating region around the conductive region. As a result, insulation between the adjacent terminals can be ensured to prevent a leakage current, thereby enhancing connection reliability between the terminals. Moreover, electric connection of a plurality of terminals can collectively be carried out even in a fine pitch circuit. Furthermore, curing of the curable resin composition increases the mechanical strength of the conductive region or the insulating region.

Hereinafter, a preferable embodiment of a method for connecting terminals according to the first embodiment of the present invention will be described with reference to the drawings, although the connection method of the present invention is not limited to these drawings.

(a) Arrangement step

First, as shown in Figure 2, a substrate 10 provided with terminals 11 is aligned with a substrate 20 provided with terminals 21 such that the terminals 11 oppose the terminals 21. Between these terminals, a conductive connecting material 30 comprising a metal foil 110 and curable resin compositions 120 provided on both sides of the metal foil 110 is arranged. In doing so, the conductive connecting material 30 may be compressed onto either or both of the substrates 10 and 20 beforehand using an instrument such as a roll laminator or a press as shown in Figure 4. If necessary, the surface of the terminals 11 and 21 may be subjected to treatments such as washing, polishing, plating and surface activation in order to achieve good electric connection.

(b) Heating step

In the heating step, the conductive connecting material arranged between the terminals in the above-described arrangement step is heated at a temperature equal to or higher than the melting point of the metal foil. The heating temperature may be equal to or higher than the melting point of the metal foil, and the upper limit thereof is not particularly limited as long as solder or tin is able to migrate within the curable resin, in other words, as long as the temperature is within the range where "the curable resin composition is not completely cured", for example, by adjusting the heating time, e.g., making the heating time shorter. The heating temperature is preferably higher by 5˚C or more, more preferably higher by 100˚C or more, still more preferably higher by 20˚C or more and particularly preferably higher by 30˚C or more than the melting point of the metal foil.

The heating temperature may appropriately be selected according to the composition of the metal foil and the curable resin composition used, but it is preferably 100˚C or higher, more preferably 130˚C or higher, particularly preferably 140˚C or higher and most preferably 150˚C or higher. In order to prevent thermal degradation of the substrates to be connected, the heating temperature is preferably 260˚C or lower, more preferably 250˚C or lower and particularly preferably 240˚C or lower.

When the conductive connecting material is heated at such a temperature, the metal foil 110 is melted and the melted solder or tin can migrate in the curable resin composition 120. When the curable resin composition contains a compound having a fluxing function, the oxide layer on the solder or tin surface is removed due to the reduction action of the compound having the fluxing function contained in the curable resin composition, and thus the wettability of the solder or tin remains in an enhanced state, which promotes metal-binding and facilitates aggregation between the opposing terminals. On the other hand, since the reduction action of the compound having the fluxing function also removes the oxide layers on the surfaces of the terminals 11 and 21 and enhances wettability thereof, metal-binding with the solder or tin is facilitated. As a result, as shown in Figure 3, a conductive region 130 is formed between the terminals, where the terminals 11 and 21 are electrically connected. Meanwhile, the surrounding area of the conductive region is filled with the curable resin composition as an insulating region 140. As a result, insulation between the adjacent terminals can be ensured, thereby preventing short-circuit between the adjacent terminals.

According to the connection method of the present invention, heating may take place while applying a pressure so as to reduce the distance between the opposing terminals. For example, a known thermal compressor or the like may be used for heating and compressing the substrates 10 and 20 shown in Figure 2 toward the facing direction so that the distance between each pair of the opposing terminals can be controlled to be constant, thereby enhancing electric connection reliability between the opposing terminals.

Furthermore, ultrasonic wave, an electric field or the like may be applied or special heating such as laser or electromagnetic induction may be applied upon compression or heating.

(c) Curing step

According to the connection method of the present invention, after forming the conductive region 130 and the insulating region 140 in the above-described heating step, the curable resin composition is cured to fix the insulating region 140. By doing so, sufficient electrical reliability and mechanical connection strength between the terminals can be ensured. In particular, according to the connection method of the present invention, since a curable resin composition having a high insulation resistance value is used, sufficient insulation of the insulating region can be ensured.

Curing of the curable resin composition can be carried out by heating the conductive connecting material. The curing temperature of the conductive connecting material may appropriately be determined according to the composition of the curable resin composition, but it is preferably a temperature lower by at least 5˚C and particularly preferably a temperature lower by at least 10˚C than the heating temperature in the above-described heating step. Specifically, the curing temperature is preferably 100˚C or higher, more preferably 120˚C or higher, particularly preferably 130˚C or higher and most preferably 150˚C or higher. At the same time, the curing temperature is preferably 300˚C or lower, more preferably 260˚C or lower, particularly preferably 250˚C or lower and most preferably 240˚C or lower. When the curing temperature lies within the above-mentioned range, the conductive connecting material is not degraded by heat, and thus the curable resin composition can adequately be cured.

(2) Second embodiment

Next, a method for connecting terminals according to the second embodiment of the present invention will be described. The method for connecting terminals according to the second embodiment of the present invention comprises the steps of: arranging the above-described conductive connecting material containing the thermoplastic resin composition and the metal foil between opposing terminals; heating the conductive connecting material at a temperature that is equal to or higher than the melting point of the metal foil and that softens the thermoplastic resin composition; and solidifying the thermoplastic resin composition. Hereinafter, each step will be described.

(a) Arrangement step

The conductive connecting material containing the thermoplastic resin composition and the metal foil can also be arranged in the same manner as the above-described conductive connecting material containing the thermally curable resin composition and the metal foil.

(b) Heating step

The heating step is not particularly limited, but the conductive connecting material arranged between the terminals in the above arrangement step is heated at a temperature equal to or higher than the melting point of the metal foil. The heating temperature is preferably higher by 5˚C or more, more preferably higher by 10˚C or more, further preferably higher by 20˚C or more and particularly preferably higher by 30˚C or more than the melting point of the metal foil. The upper limit of the heating temperature is not particularly limited as long as it is equal to or higher than the melting point of the metal foil and it softens the thermoplastic resin so that the solder or tin is able to migrate within the thermoplastic resin, in other words, the temperature is within the range where "the Thermoplastic resin composition is softened".

The heating temperature may appropriately be selected according to the composition of the metal foil and the thermoplastic resin composition used. For example, heating can be carried out at the same heating temperature as that for the conductive connecting material containing the curable resin composition and the metal foil.

When the conductive connecting material is heated at the above-described temperature, the metal foil 110 is melted so that the melted solder or tin can migrate in the thermoplastic resin composition 120. When the thermoplastic resin composition contains a compound having a fluxing function, the oxide layer on the solder or tin surface is removed due to the reduction action of the compound having the fluxing function contained in the thermoplastic resin composition, and thus the wettability of the solder or tin remains in an enhanced state, which promotes metal-binding and facilitates aggregation between the opposing terminals. On the other hand, since the reduction action of the compound having the fluxing function also removes the oxide layers on the surfaces of the terminals 11 and 21 and enhances wettability thereof, metal-binding of the solder or tin is facilitated. As a result, as shown in Figure 3, a conductive region 130 is formed between the terminals, where the terminals 11 and 21 are electrically connected. Meanwhile, the surrounding area of the conductive region is filled with the thermoplastic resin composition as an insulating region 140. As a result, insulation between the adjacent terminals can be ensured, thereby preventing short-circuit between the adjacent terminals.

(c) Solidification step

According to the connection method of the present invention, after forming the conductive region 130 and the insulating region 140 in the heating step, the thermoplastic resin composition is solidified to fix the insulating region 140. By doing so, sufficient electrical reliability and mechanical connection strength between the terminals can be ensured.
Solidification of the thermoplastic resin composition may be carried out by cooling/solidifying the conductive connecting material that has been heat-melted in the above-described heating step. The cooling/solidification of the conductive connecting material may appropriately be determined according to the composition of the thermoplastic resin composition, which is not particularly limited, and it may be a method carried out by natural cooling or a method carried out by spraying cool air.
The solidifying temperature of the thermoplastic resin composition is not particularly limited but it is preferably lower than the melting point of a metal foil. More specifically, the solidifying temperature of the thermoplastic resin composition is preferably lower by 10°C or more and particularly preferably lower by 20°C or more than the melting point of the metal foil. At the same time, the solidifying temperature of the thermoplastic resin composition is preferably 50°C or higher, particularly preferably 60°C or higher, and still more preferably 100°C or higher. When the solidifying temperature of the thermoplastic resin composition lies within the above-mentioned range, formation of the conductive region 130 can be ensured, and the insulating region 140 may have a desirable heat resistance. As a result, insulation between the adjacent terminals can be ensured, thereby preventing short-circuit to be caused between the adjacent terminals.
In a preferable aspect of the present invention, by using a conductive connecting material comprising a resin composition containing a certain resin component and a compound having a fluxing function and a metal foil, the solder or tin can selectively be aggregated between the opposing terminals to electrically connect the terminals and insulation between the adjacent terminals can be ensured. Furthermore, a plurality of terminals can be conducted collectively and terminal connection can be realized with excellent reliability.

3. Method for producing connection terminal

Next, a method for producing a connection terminal according to the present invention will be described.
A method for producing a connection terminal according to the present invention comprises a method for producing a connection terminal on an electrode of an electronic member by using the above-described conductive connecting material, the method comprising the steps of: arranging the conductive connecting material on the electrode of the electronic member; heating the conductive connecting material; and, if necessary, solidifying the resin composition. A method for producing a connection terminal according to the present invention may be used, for example, for producing a connection terminal on an electrode of a semiconductor wafer, a semiconductor chip, a rigid substrate, a flexible substrate, and other electrical or electronic component.
According to the production method of the present invention, the production step of the connection terminal slightly varies between the case where the resin composition of the conductive connecting material is a curable resin composition and the case where it is a thermoplastic resin composition. Hereinafter, a first embodiment refers to a case where the resin composition of the conductive connecting material is a curable resin composition while a second embodiment refers to a case where the resin composition is a thermoplastic resin composition. Each of the embodiments will be described.

(1) First embodiment

A method for producing a connection terminal according to the first embodiment of the present invention comprises the steps of: arranging the above-described conductive connecting material including the curable resin composition and the metal foil on an electrode of an electronic member; heating the conductive connecting material at a temperature that is equal to or higher than the melting point of the metal foil and that does not complete curing of the curable resin composition; and, if necessary, solidifying the resin composition.
According to this method for producing the connection terminal, heat-melted solder or tin can selectively be aggregated on the electrode of the substrate to form a connection terminal while an insulating region can be formed with the curable resin composition around the connection terminal. Accordingly, since the surrounding area of the connection terminal can be coated with the curable resin composition, the conductive region can be fixed. Moreover, since insulation between the adjacent connection terminals can be ensured by the insulating region, connection reliability can be enhanced. According to this method, a plurality of connection terminals can collectively be produced even in a fine pitch circuit.
Hereinafter, with reference to the drawings, a method for producing a connection terminal according to the first embodiment of the present invention will be described in more detail. However, the connection method of the present invention is not limited to these drawings.

(a) Arrangement step

First, as shown in Figure 5, a conductive connecting material having a curable resin composition 120 and a metal foil 110 are arranged on a substrate 40 provided with electrodes 41. Here, in a case where a patterned metal foil is used, the conductive connecting material 50 and the electrodes 41 on the substrate need to be aligned with each other. Although the metal foil 110 having the curable resin composition 120 on one side is used in Figure 5, the curable resin composition 120 may be formed on both sides of the metal foil 110. In addition, although the curable resin composition 120 is arranged to face the connection terminals in Figure 5, the metal foil 110 may be arranged to face the connection terminals.
As shown in Figure 5, the conductive connecting material 50 may thermally be compressed with the substrate 40 using a device such as a roll laminator, a press or the like. Although a curable resin composition 120 covers electrodes 41 in Figure 6, the thickness of the thermally cured resin composition 120 may be thinner or thicker than the thickness of the electrodes 41, and may appropriately be adjusted according to purpose, application and the like. If necessary, the surface of the electrodes 41 may be subjected to treatments such as washing, polishing, plating and surface activation in order to achieve good electric connection or enhance junction property with the metal foil.

(b) Heating step

In the heating step, the conductive connecting material 50 arranged on the electrodes 41 on the substrate 40 in the above-described arrangement step is heated at a temperature that is equal to or higher than the melting point of the metal foil but that does not complete the curable resin composition. By doing so, as shown in Figure 7, connection terminals 150 can be formed on the electrodes 41. Meanwhile, the surrounding area of the connection terminal 150 is filled with the curable resin composition as an insulating region 140. As a result, insulation between the adjacent connection terminals 150 can be ensured, thereby preventing short-circuit to be caused between the adjacent connection terminals.
The heating temperature and pressurization conditions for the curable resin composition may be the same as those for the above-described case of terminal-to-terminal connection using the conductive connecting material having the curable resin composition and the metal foil.

(c) Solidification step

In the solidification step following the formation of the connection terminal and the insulating region in the above-described heating step, the thermally curable resin composition is cooled and solidified to fix the insulating region, thereby reinforcing the junction between the electrode and the connection terminal. A method for cooling the thermally curable resin composition is not particularly limited, and it may be a method carried out by natural cooling or a method carried out by spraying cool air. The solidifying temperature is preferably lower by 10˚C or more and particularly preferably lower by 20˚C or more than the melting point of a metal foil. At the same time, the solidifying temperature is preferably 50˚C or higher, more preferably 60˚C or higher and still more preferably 100˚C or higher.

(2) Second embodiment

Next, a method for producing a connection terminal according to a second embodiment of the present invention will be described.
A method for producing a connection terminal according to the second embodiment of the present invention comprises the steps of: arranging the above-described conductive connecting material including the thermoplastic resin composition and the metal foil on an electrode of an electronic member; heating the conductive connecting material at a temperature that is equal to or higher than the melting point of the metal foil and that softens the thermoplastic resin composition; and, if necessary, solidifying the thermoplastic resin composition.
According to the production method of the second embodiment, heat-melted solder or tin can selectively be aggregated on the electrode on the substrate to form a connection terminal while an insulating region can be formed with the thermoplastic resin composition around the connection terminal. Accordingly, since the surrounding area of the connection terminal can be coated with the thermoplastic resin composition, the conductive region can be fixed. Moreover, since insulation between the adjacent connection terminals can be ensured by the insulating region, connection reliability can be enhanced. According to this method, a plurality of connection terminals can collectively be produced even in a fine pitch circuit.

(a) Arrangement step

The conductive connecting material including the thermoplastic resin composition and the metal foil can be arranged on a substrate provided with electrodes in the same manner as the first embodiment in which the conductive connecting material including the thermally curable resin composition and the metal foil is used.

(b) Heating step

In the heating step, the conductive connecting material 50 arranged on the electrodes provided on the substrate in the above-described arrangement step is heated at a temperature that is equal to or higher than the melting point of the metal foil and that softens the thermoplastic resin composition. By doing so, similar to the first embodiment, connection terminals can be formed on the electrodes. Meanwhile, the surrounding area of the connection terminal is filled with the thermoplastic resin composition as an insulating region. As a result, insulation between the adjacent connection terminals can be ensured, thereby preventing short-circuit to be caused between the adjacent connection terminals.

The heating temperature and pressurization conditions for the thermoplastic resin composition may be the same as those for the above-described case of terminal-to-tenninal connection using the conductive connecting material having the thermoplastic resin composition and the metal foil.

(c) Solidification step

In the solidification step following the formation of the connection terminal and the insulating region in the above-described heating step, the thermoplastic resin composition is cooled and solidified to fix the insulating region, thereby reinforcing the junction between the electrode and the connection terminal.
The cooling method and preferable solidifying temperature for the thermoplastic resin composition are the same as those for the above-described terminal-to-terminal connection using the conductive connecting material having the thermoplastic resin composition and the metal foil.

According to the present invention, as described above, since solder or tin can selectively be aggregated on a site where the connection terminal is to be formed by using the conductive connecting material of the invention, the connection terminal can be produced by a simple method. According to the method for producing a connection terminal of the present invention, not only a plurality of connection terminals can collectively be produced, but also insulating regions can be formed around them, by which the connection terminals can be fixed while insulation between the adjacent connection terminals can be ensured. Thus, the connection terminal(s) superior in connection reliability can be produced.

4. Electronic members and electrical and electronic components associated with conductive connecting material

The present invention also comprises an electronic member associated with a conductive connecting material, where the conductive connecting material of the present invention is adhered to the electrically connecting surface of the electronic member. In the electronic member associated with the conductive connecting material of the present invention, the surface of the conductive connecting material that adheres to the electrically connecting surface of the electronic member is preferably a resin composition layer. The resin composition layer may be adhered directly to the electrically connecting surface of the electronic member, or may be adhered via an adhesive layer. The electronic members associated with the conductive connecting material of the present invention may be layered with each other or the electronic member associated with the conductive connecting material of the present invention may be layered with an electrically connecting surface of other electronic member, which are then thermally compressed with each other so as to electrically connect the electronic members.
The present invention also comprises a semiconductor wafer, a semiconductor chip, a rigid substrate, a flexible substrate and other electrical and electronic components in which electronic members are electrically connected using the thus-obtained conductive connecting material of the present invention.

EXAMPLES

Hereinafter, the present invention will be described by way of examples, although the present invention should not be limited to the following examples.

Examples 1-9

(1) Preparation of curable resin composition

The components shown in Table 1 were dissolved in methylethyl ketone (MEK) to obtain a varnish of a resin composition having a solid content of 40%. The obtained varnish was applied to a polyester sheet with a comma coater, and dried at 90°C for 5 minutes to obtain a curable resin composition with a film thickness of 30 μm.

(2) Production of conductive connecting material

The resulting film-like curable resin composition was laminated on both sides of the solder foil shown in Table 1 under the conditions of 60°C, 0.3MPa and 0.3m/min to produce a conductive connecting material having a thickness of 70 μm.

(3) Terminal-to-terminal connection

Then, the resulting conductive connecting material was used to carry out terminal-to-terminal connection of a substrate. The substrate used consisted of FR-4-based material (thickness: 0.1 mm) and a circuit layer (copper circuit, thickness: 12 μm), which had connection terminals formed by plating Ni/Au (thickness: 3 μm) on the copper circuit (terminal diameter: 100 μm, distance between centers of adjacent terminals: 300 μm). The conductive connecting material was arranged between such substrates having the connection terminals, to which thermal compression (gap between substrates: 50 μm) was performed using a thermal compressor ("TMV1-200ASB" from Tsukuba Mechanics) under the conditions shown in Table 1 to connect the terminals. Thereafter, the curable resin composition was cured by heating at 180°C for an hour, thereby obtaining a multi-layered body.

Examples 10 and 11

The components shown in Table 1 were agitated to prepare a curable resin composition that was in a liquid form at 25°C. A solder foil shown in Table 1 was immersed in the resulting curable resin composition that was in the liquid form at 25°C so as to apply the curable resin composition in a liquid form to both sides of the solder foil to produce a conductive connecting material. Furthermore, the resulting conductive connecting material was used to carry out terminal-to-terminal connection for substrates in the same manner as the methods in Examples 1-9 (method described in "(3) Terminal-to-terminal connection" above).

Comparative example 1

A curable resin composition was prepared in the same manner as in Examples 1-9. The resulting curable resin composition with a thickness of 30 μm was laminated on both sides of a solder foil shown in Table 2 to produce a conductive connecting material. Furthermore, the resulting conductive connecting material was used to carry out terminal-to-terminal connection for substrates in the same manner as the methods in Examples 1-9 (method described in "(3) Terminal-to-terminal connection" above).

Comparative example 2

A curable resin composition was prepared in the same manner as in Examples 10 and 11. The resulting curable resin composition was adhered to both sides of a solder foil shown in Table 2 to produce a conductive connecting material. Furthermore, the resulting conductive connecting material was used to carry out terminal-to-terminal connection for substrates in the same manner as the methods in Examples 1-9 (method described in "(3) Terminal-to-terminal connection" above).

The ion viscosity, the time of the maximum peak of the ion viscosity slope to appear and the thermogravimetric weight loss of each of the resin compositions prepared in Examples and Comparative examples were measured according to the following methods. Moreover, electrical resistance between the opposing terminals, formation of conductivity path, presence or absence of residual solder particles in regions other than the conductivity path and void in the resulting multi-layered body were assessed by methods described below.

(1) Ion viscosity and time of appearance of maximum peak of ion viscosity slope

When the resin composition is in a solid form at ambient temperature (Examples 1-9, Comparative Example

1), DEA231/1 cure analyzer from NETZSCH and MP235 Mini-Press from NETZSCH were used as a dielectric analyzer and a press, respectively. The measurement method was carried out in accordance with ASTM standard E2039 at the melting point of the solder foils shown in Tables 1 and 2 under the conditions of a frequency of 10000Hz, in which a curable resin composition having a thickness of about 0.5 mm was set and pressed on the upper surface of the electrode in the press and then subjected to measurement. The minimum value of the resulting ion viscosity was defined as the measurement value. In addition, the ion viscosity slope was calculated from the differential values of the obtained ion viscosity, and time of appearance of the maximum peak thereof was defined as the measurement value.
When the resin composition is in a liquid form at ambient temperature (Examples 10 and 11, Comparative Example 2), DEA231/1 cure analyzer from NETZSCH and 036S-IDEX from NETZSCH were used as a dielectric analyzer and a dielectric measurement sensor, respectively. The measurement method was carried out in accordance with ASTM standard E2039 at the melting point of the solder foils shown in Tables 1 and 2 under the conditions of a frequency of 10000Hz, in which a curable resin composition was applied to the dielectric measurement sensor to a thickness of about 0.5 mm, heated in an oven and then subjected to measurement. The minimum value of the resulting ion viscosity was defined as the measurement value. In addition, the ion viscosity slope was calculated from the differential values of the obtained ion viscosity, and time of appearance of the maximum peak thereof was defined as the measurement value.
The measurement results of the ion viscosity and the ion viscosity slope obtained for the curable resin compositions of Examples 1-3 are shown in Figures 8-10, respectively.

(2) Thermogravimetric weight loss

A differential thermal/thermogravimetric simultaneous measurement instrument (TG/DTA 6200 from Seiko Instruments) was used. About 10 mg of the resin composition was set on a thermoscale and heated from 30˚C to the melting point of the metal foil at a temperature rising rate of 10˚C/min. The thermogravimetric weight loss at the melting point of the metal foil was defined as the measurement value.

(3) Electrical resistance

Electrical resistances between the opposing terminals of the multi-layered body were measured by 12 point measurement using four-terminal method (resistance meter: "Digital Multimeter VOA7510" from Iwatsu Electric, measurement probe: "Pin-type lead 9771" from Hioki E.E.). The assessments were as follows: "A" when the average value was less than 30 mΩ; and "B" when the average value was equal to or higher than 30 mΩ.

(4) Formation of conductivity path

For 10 pairs of opposing terminals of the multi-layered body, the cross-sections between the terminals were observed with a scanning electronic microscope (SEM) ("JSM-7401F" from JEOL). Assessments were as follows: "A" when cylindrical conductivity paths were formed with solder in all of the 10 pairs; "B" when any pair of terminals failed to form a conductivity path; and "C" when a short-circuit is made with the adjacent terminals.

(5) Presence and absence of residual solder

The cross-section of the multi-layered body was observed with a scanning electronic microscope (SEM) (model number "JSM-7401F" from JEOL), and it was assessed as follows: "A" when the solder entirely contributed to the formation of the conductivity path between opposing terminals; and "B" when the solder did not entirely contribute to the formation of the conductivity path and remained in a region of the resin (insulating region) other than the region between the opposing terminals (conductive region).

(6) Void

The multi-layered bodies were observed with an ultrasonic scanning device (SAT) (model number "mi-scope10" from Hitachi Kenki Fine Tech) and those having a void area of less than 10% to the adhering surface area were assessed to be "A" whereas those having a void area equal to or more than 10% were assessed to be "B".

(7) Overall assessment

In the assessments (3)-(6) above, those associated with practically no problem were assessed "○" and those with practical problem were assessed "×".
The results are shown in Tables 1 and 2.

Table 1

| | | | Example 1 | Example 2 | Example 3 | Example 4 | Example 5 | Example 6 | Example 7 | Example 8 | Example 9 | Example 10 | Example 11 |
|---|---|---|---|---|---|---|---|---|---|---|---|---|---|
| Composition [parts by weight] | Resin composition | Epoxy resin 1 | 40 0 | 40.0 | 40 0 | 40 0 | 40 0 | 50 0 | 40 0 | 40 0 | 38.5 | 80.0 | 65.0 |
| | | Epoxy resin 2 | | | | | | | | | | | 15.0 |
| | | Curing agent 1 | 25 0 | 25 0 | 25 0 | 20 0 | 25 0 | 35 0 | 23 5 | 19 5 | 25 0 | | |
| | | Film-forming resin 1 | 30 0 | 30 0 | 30 0 | 35 0 | | | 30 0 | 30 0 | 30 0 | | |
| | | Film-forming resin 2 | | | | | 30 0 | | | | | | |
| | | Film-forming resin 3 | | | | | | 10 0 | | | | | |
| | | Compound having fluxing function 1 | 4.5 | 4 5 | 4 5 | 4 5 | 4 5 | 4 5 | 2 0 | | 4 5 | 4 0 | 4 0 |
| | | Compound having fluxing function 2 | | | | | | | 4 0 | | | 15 5 | 15 5 |
| | | Compound having fluxing function 3 | | | | | | | | 10 0 | | | |
| | | Silane coupling agent 1 | 0 5 | 0 5 | 0 5 | 0 5 | 0 5 | 0 5 | 0 5 | 0 5 | 0 5 | 0 5 | 0 5 |

(continued)

| | | | Example 1 | Example 2 | Example 3 | Example 4 | Example 5 | Example 6 | Example 7 | Example 8 | Example 9 | Example 10 | Example 11 |
|---|---|---|---|---|---|---|---|---|---|---|---|---|---|
| | | limdazole 1 | 001 | 0 01 | 0 01 | 0.01 | 0.01 | 0 01 | 0 01 | 0 01 | 0 50 | 0 02 | 0 02 |
| | | Total | 100 0 | 100 0 | 100 0 | 100 0 | 100 0 | 100 0 | 100 0 | 100 0 | 100 0 | 100 0 | 100 0 |
| | Metal foil | Solder foil A | ○ | | | | | | | | | | |
| | | Solder foil B | | ○ | | ○ | ○ | ○ | ○ | ○ | | ○ | |
| | | Solder foil C | | | ○ | | | | | | ○ | | ○ |
| Properties of curable resin composition | Minimum ion viscosity of curable resin composition at melting point of metal foil [-] | | 74 | 70 | 6.9 | 72 | 75 | 8 1 | 6.9 | 7 3 | 7 7 | 5 2 | 1 8 |
| | Time of appearance of maximum peak of ion viscosity slope of curable resin composition at melting point of metal foil [second] | | 270 | 125 | 51 | 121 | 130 | 112 | 118 | 109 | 7 | 85 | 46 |
| | Thermogravimetric weight loss of curable resin composition at melting point of metal foil [% by weight] | | 0 2 | 0 3 | 0 3 | 0 3 | 03 | 0 3 | 0 3 | 0 3 | 0 3 | 0 2 | 5 6 |
| Substrate connecting conditions | Thermal compression Conditions | Temperature [˚C] | 160 | 200 | 230 | 200 | 200 | 200 | 200 | 200 | 230 | 200 | 230 |
| | | Pressure [MPa] | 2 | 0 5 | 0 5 | 0 5 | 0 5 | 0 5 | 0 5 | 0 5 | 0 5 | 0 5 | 0 5 |
| | | Time [second] | 600 | 120 | 120 | 120 | 120 | 120 | 120 | 120 | 120 | 120 | 120 |
| Evacuation Results | Electrical resistance between opposing terminals | | A | A | A | A | A | A | A | A | A | A | A |

(continued)

| | | Example 1 | Example 2 | Example 3 | Example 4 | Example 5 | Example 6 | Example 7 | Example 8 | Example 9 | Example 10 | Example 11 |
|---|---|---|---|---|---|---|---|---|---|---|---|---|
| | Formation of conductivity path between opposing terminals | A | A | A | A | A | A | A | A | A | A | A |
| | Presence or absence of residual solder | A | A | A | A | A | A | A | A | B | A | A |
| | Void | A | A | A | A | A | A | A | A | A | A | B |
| | Overall assessment | ○ | ○ | ○ | ○ | ○ | ○ | ○ | ○ | ○ | ○ | ○ |

Table 2

| | | | Comparative Example 1 | Comparative Example 2 |
|---|---|---|---|---|
| Composition [parts by weight] | Resin composition | Epoxy resin 1 | 30 0 | |
| | | Epoxy resin 2 | | 5.0 |
| | | Epoxy resin 3 | | 75.0 |
| | | Curing agent 1 | 19 5 | |
| | | Film-forming resin 3 | 40 0 | |
| | | Compound having fluxing function 1 | | 4 0 |
| | | Compound having fluxing function 2 | | 15 5 |
| | | Compound having fluxing function 3 | 10 0 | |
| | | Silane coupling agent 1 | 0 5 | 0 5 |
| | | Imidazole 1 | 0.01 | 0 02 |
| | | Total | 100 0 | 100 0 |
| | | Solder foil A | | |
| | Metal foil | Solder foil B | ○ | ○ |
| | | Solder foil C | | |
| Properties of curable resin composition | Ion viscosity of curable resin composition at melting point of metal foil [Pa s] | | 10 3 | 3 8 |
| | Time of appearance of maximum peak of ion viscosity slope of curable resin composition at melting point of metal foil [second] | | - | 76 |
| | Thermogravimetric weight loss of curable resin composition at melting point of metal foil [% by weight] | | 0.2 | 1.5 |
| Substrate connecting conditions | Thermal compression Conditions | Temperature [°C] | 200 | 200 |
| | | Pressure [MPa] | 0.5 | 0.5 |
| | | Time [second] | 120 | 120 |
| Evaluation Results | Electrical resistance between opposing terminals | | B | B |
| | Formation of conductivity path between opposing terminals | | B,C | B |
| | Presence or absence of residual solder | | B | A |
| | Void | | A | A |
| | Overall assessment | | × | × |

The components of the resin compositions and the solder foils used in Table 1 and 2 are shown below.
Epoxy resin 1: Bisphenol-A epoxy resin, "EPICLON-840S" from Dainippon Ink and Chemicals, epoxy equivalent: 185 g/eq
Epoxy resin 2: Cresyl glycidyl ether, "m,p-CGE" from Sakamoto Yakuhin Kogyo, epoxy equivalent: 185 g/eq
Epoxy resin 3: Bisphenol-F epoxy resin, "RE-403S" from Nippon Kayaku, epoxy equivalent: 165 g/eq
Curing agent 1: Phenol novolac, "PR-53647" from Sumitomo Bakelite

Film-forming resin 1: Modified, biphenol phenoxy resin, "YX-6954" from Japan Epoxy Resin, weight-average molecular weight: 39,000
Film-forming resin 2: Modified, bisphenol-F phenoxy resin, "4256H40" from Japan Epoxy Resin, weight-average molecular weight: 62,000
Film-forming resin 3: Acrylic acid ester copolymer, "SG-P3" from Nagase ChemteX, weight-average molecular weight 850,000
Compound having fluxing function 1: Sebacic acid, "Sebacic acid" from Tokyo Chemical Industry
Compound having fluxing function 2: Gentisic acid, "Gentisic acid" from Midori Kagaku
Compound having fluxing function 3: Phenolphthalin, "Phenolphthalin" from Tokyo Chemical Industry
Silane coupling agent 1: 2-(3,4-epoxycyclohexyl)ethyltrimethoxysilane, "KBM-303" from Shin-Etsu Chemical, boiling point: 310˚C
Imidazole 1: 2-phenyl-4-methylimidazole, "Curezol 2P4MZ" from Shikoku Chemicals
Solder foil A: Sn/Bi = 42/58 (melting point: 139˚C), thickness: 10 μm
Solder foil B: Sn/Pb = 63/37 (melting point: 183˚C), thickness: 10 μm
Solder foil C: Sn/Ag/Cu = 96.5/3.0/0.5 (melting point: 217˚C), thickness: 10 μm

As can be appreciated from Tables 1 and 2, it was found that good electric connection can be obtained without causing a short-circuit between the adjacent terminals by using a resin composition having the minimum ion viscosity value within a range of 4-9 as a resin composition layer of a conductive connecting material. In addition, solder or tin can sufficiently migrate before curing of the resin composition proceeds and thus solder can be prevented from remaining in the insulating region, by using a resin composition whose maximum peak of the ion viscosity slope appears after 10 or more seconds from the initiation of the measurement. Furthermore, it was found that void generation can be prevented by using a resin composition having a thermogravimetric weight loss of 5% by weight.

INDUSTRIAL APPLICABILITY

A conductive connecting material of the present invention can favorably be used for electrically connecting electronic members of an electrical or electronic component or for producing a connection terminal on a substrate. By using the conductive connecting material of the present invention, good electric connection between the electronic members as well as highly-reliable insulation can be achieved at the same time. By using the conductive connecting material of the present invention, terminal-to-terminal connection in a fine pitch circuit can be realized. By using the conductive connecting material of the present invention, one can cope with the needs for enhanced performance and downsizing of electronic devices.

DESCRIPTION OF REFERENCE NUMERALS

| | |
|---|---|
| 10, 20... | Substrates |
| 11, 21... | Terminals |
| 110... | Metal foil |
| 120... | Resin composition |
| 130... | Conductive region |
| 140... | Insulating region |

**Claims**

1. A conductive connecting material having a multi-layered structure comprising a resin composition and a metal foil selected from a solder foil or a tin foil, wherein the minimum ion viscosity value of the resin composition is 4-9 when measured in accordance with ASTM standard E2039 by applying a frequency of 10000Hz at the melting point of the metal foil.

2. The conductive connecting material according to Claim 1, wherein the maximum peak of the ion viscosity slope of

the resin composition appears 10 or more seconds from the initiation of the measurement when measured in accordance with ASTM standard E2039 by applying a frequency of 10000Hz at the melting point of the metal foil.

**3.** The conductive connecting material according to either one of Claims 1 and 2, wherein the thermogravimetric weight loss of the resin composition is 5% by weight or less when measured by heating from 30˚C to the melting point of the metal foil at a temperature rising rate of 10˚C/min.

**4.** The conductive connecting material according to any one of Claims 1-3, wherein the resin composition comprises an epoxy resin and a curing agent.

**5.** The conductive connecting material according to Claim 4, wherein the curing agent comprises at least one type selected from the group consisting of phenols, acid anhydrides and amine compounds.

**6.** The conductive connecting material according to any one of Claims 1-5, wherein the resin composition further comprises a film-forming resin.

**7.** The conductive connecting material according to Claim 6, wherein a weight-average molecular weight of the film-forming resin is 8,000-1,000,000.

**8.** The conductive connecting material according to either one of Claims 6 and 7, wherein the film-forming resin comprises at least one type selected from the group consisting of a phenoxy resin, a (meth)acrylic resin and a polyimide resin.

**9.** The conductive connecting material according to any one of Claims 6-8, wherein the resin composition comprises, with respect to the total weight of the resin composition, 10-90% by weight of the epoxy resin, 0.1-50% by weight of the curing agent and 5-50% by weight of the film-forming resin.

**10.** The conductive connecting material according to any one of Claims 1-9, wherein the resin composition comprises a compound having a fluxing function.

**11.** The conductive connecting material according to Claim 10, wherein the compound having the fluxing function comprises a phenolic hydroxyl group and/or a carboxyl group.

**12.** The conductive connecting material according to either one of Claims 10 and 11, wherein the compound having the fluxing function comprises a compound represented by General Formula (1) below:

$$HOOC\text{-}(CH_2)n\text{-}COOH \qquad (1)$$

where n is an integer of 1-20.

**13.** The conductive connecting material according to either one of Claims 10 or 11, wherein the compound having the fluxing function comprises a compound represented by General Formula (2) and/or (3) below:

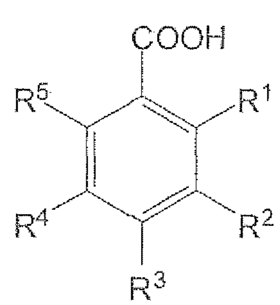

(2)

where $R^1$-$R^5$ each independently represent a monovalent organic group, providing that at least one of $R^1$-$R^5$ is a hydroxyl group,

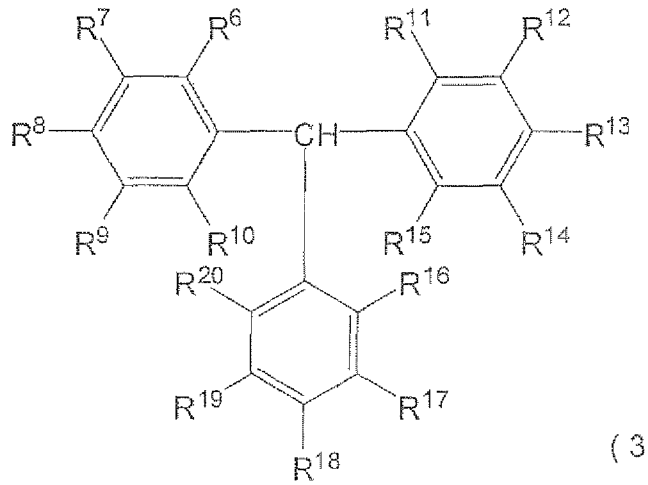

(3)

where $R^6$-$R^{20}$ each independently represent a monovalent organic group, providing that at least one of $R^6$-$R^{20}$ is a hydroxyl group or a carboxyl group.

**14.** The conductive connecting material according to any one of Claims 10-13, wherein the resin composition comprises the compound having the fluxing function for a total of 1-50% by weight with respect to the total weight of the resin composition.

**15.** The conductive connecting material according to any one of Claims 1-14, wherein the melting point of the metal foil is 100˚C-330˚C.

**16.** The conductive connecting material according to any one of Claims 1-15, comprising a multi-layered structure comprising resin composition layer/metal foil layer/resin composition layer.

**17.** The conductive connecting material according to any one of Claims 1-15, comprising a multi-layered structure comprising resin composition layer/metal foil layer.

**18.** A method for connecting terminals, comprising the steps of: arranging the conductive connecting material according to any one of Claims 1-17 between the opposing terminals; heating the conductive connecting material at a temperature that is equal to or higher than the melting point of the metal foil but that does not complete curing of the resin composition; and curing the resin composition.

**19.** A method for connecting terminals, comprising the steps of: arranging the conductive connecting material according to any one of Claims 1-17 between opposing terminals; heating the conductive connecting material at a temperature that is equal to or higher than the melting point of the metal foil and that softens the resin composition; and solidifying the resin composition.

**20.** A method for producing a connection terminal, comprising the steps of: arranging the conductive connecting material according to any one of Claims 1-17 on an electrode of an electronic member; and heating the conductive connecting material at a temperature that is equal to or higher than the melting point of the metal foil but that does not complete curing of the resin composition.

**21.** A method for producing a connection terminal, comprising the steps of: arranging the conductive connecting material according to any one of Claims 1-17 on an electrode of an electronic member; heating the conductive connecting material at a temperature that is equal to or higher than the melting point of the metal foil and that softens the resin composition; and solidifying the resin composition.

**22.** An electronic member associated with a conductive connecting material, wherein the conductive connecting material according to any one of Claims 1-17 is adhered to an electrically connecting surface of the electronic member.

**23.** An electrical or electronic component, wherein electronic members are electrically connected using the conductive connecting material according to any one of Claims 1-17.

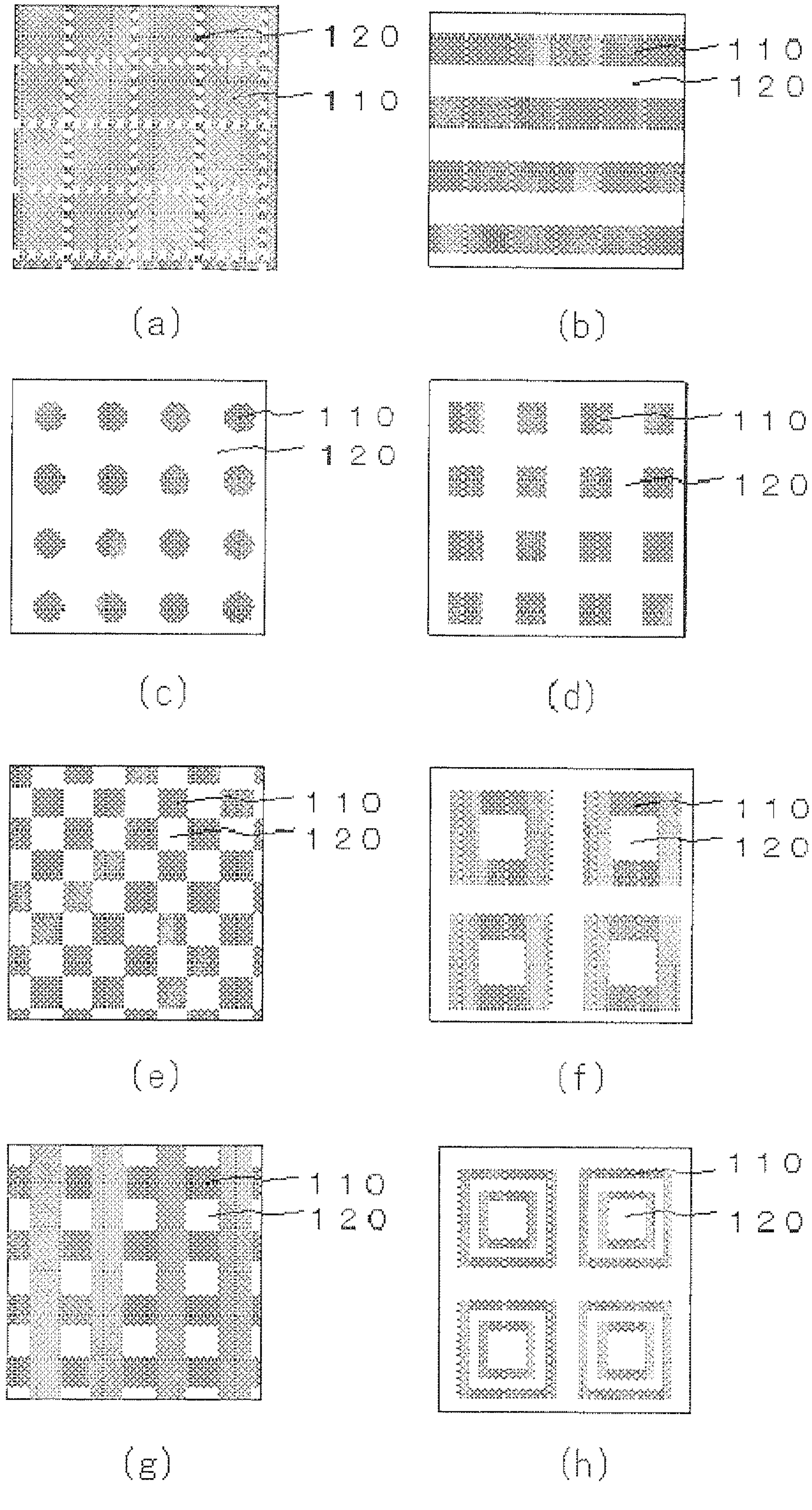
120
110
(a)
110
120
(b)
110
120
(c)
110
120
(d)
110
120
(e)
110
120
(f)
110
120
(g)
110
120
(h)

Fig. 1

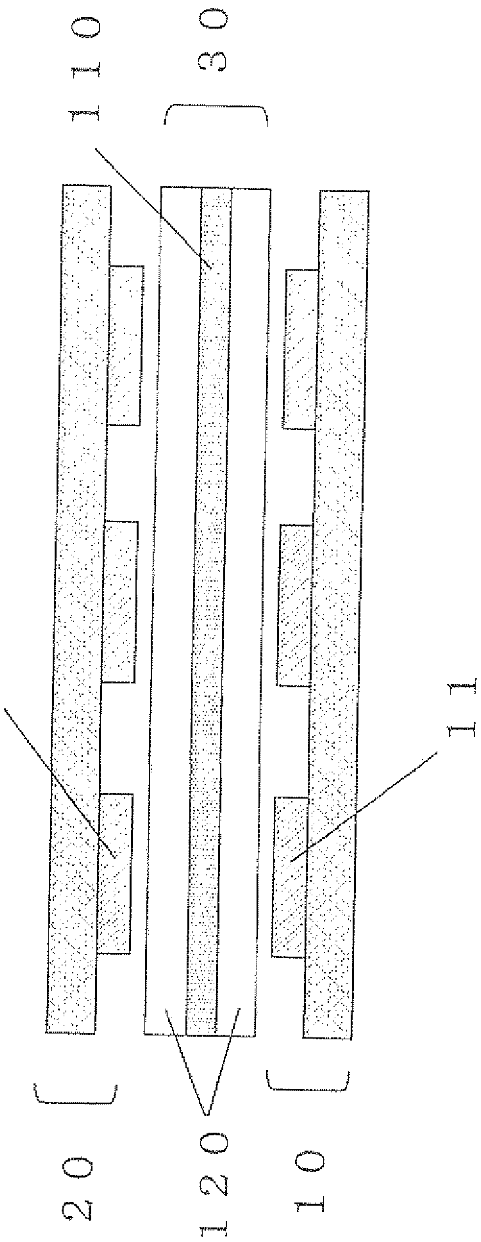


Fig. 2

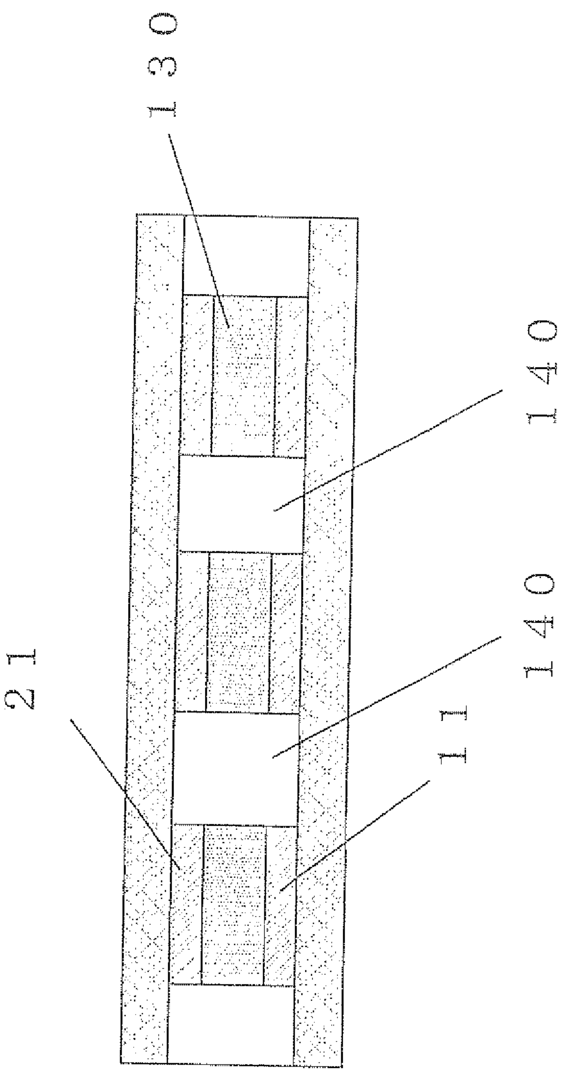


Fig. 3

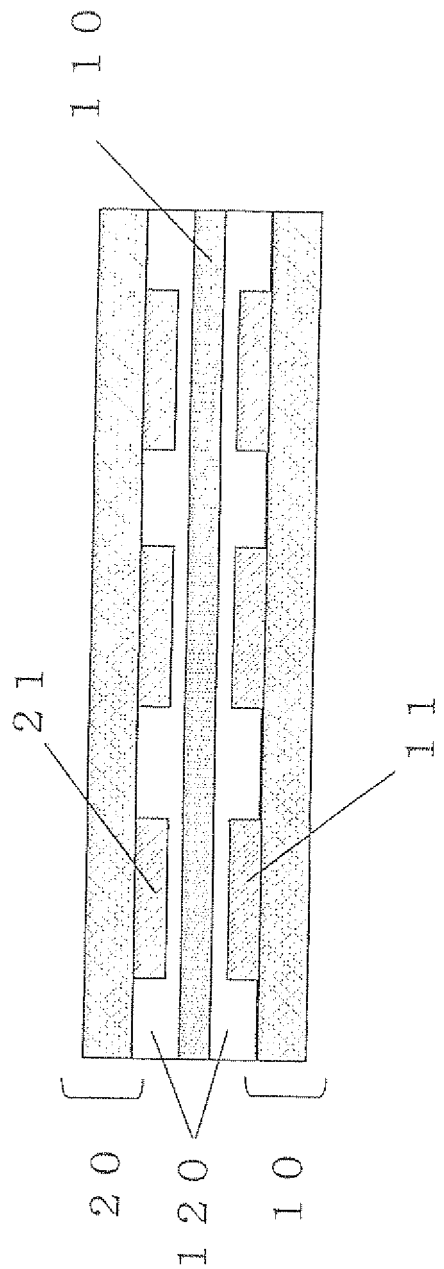


Fig. 4

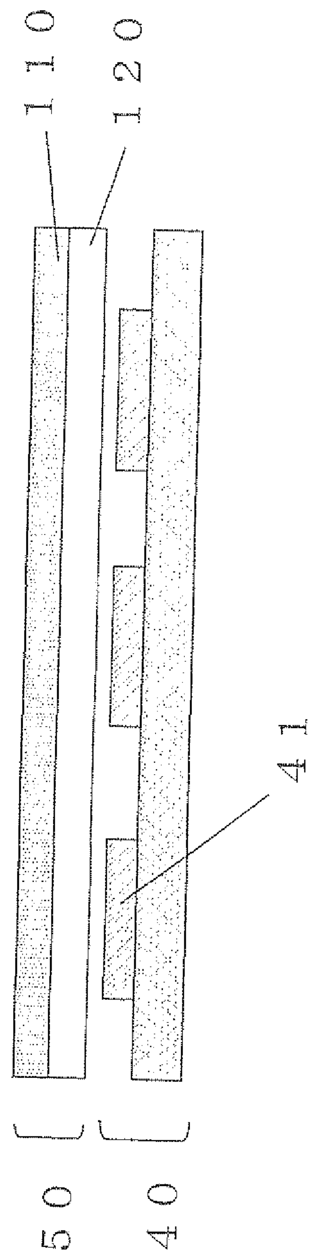


Fig. 5

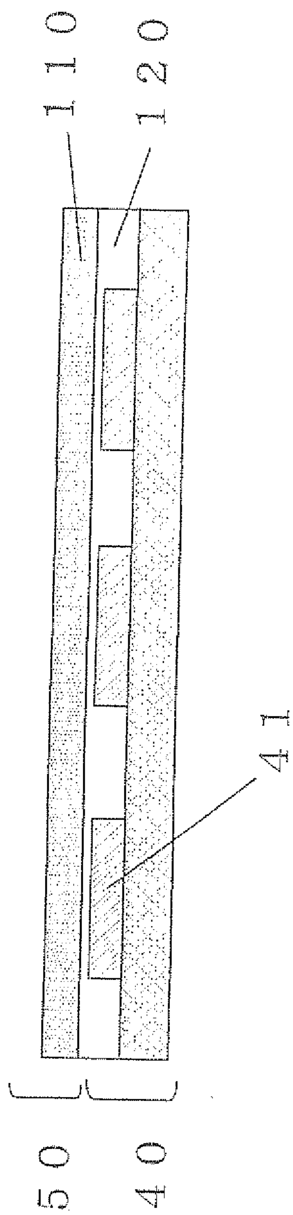


Fig. 6

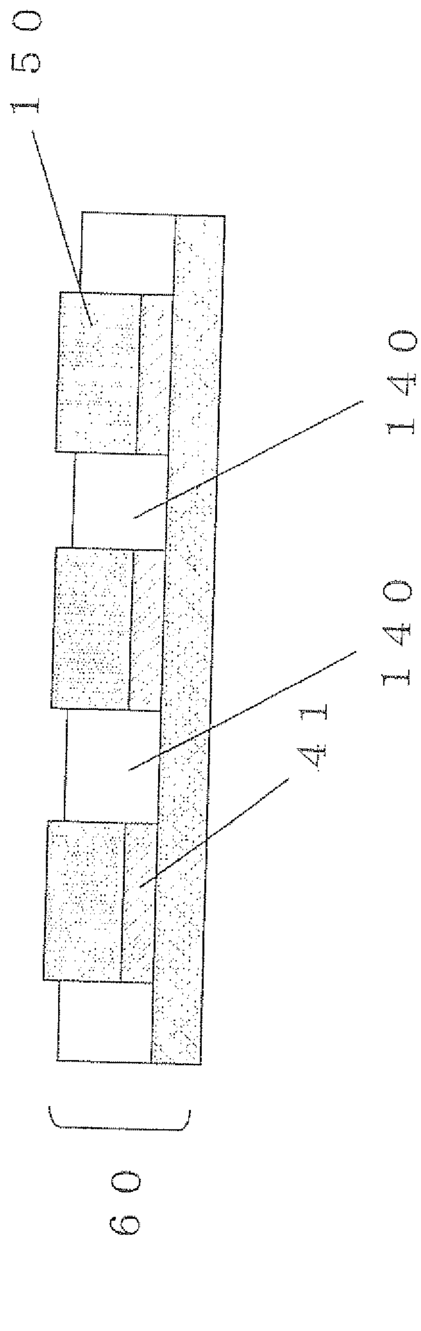


Fig. 7

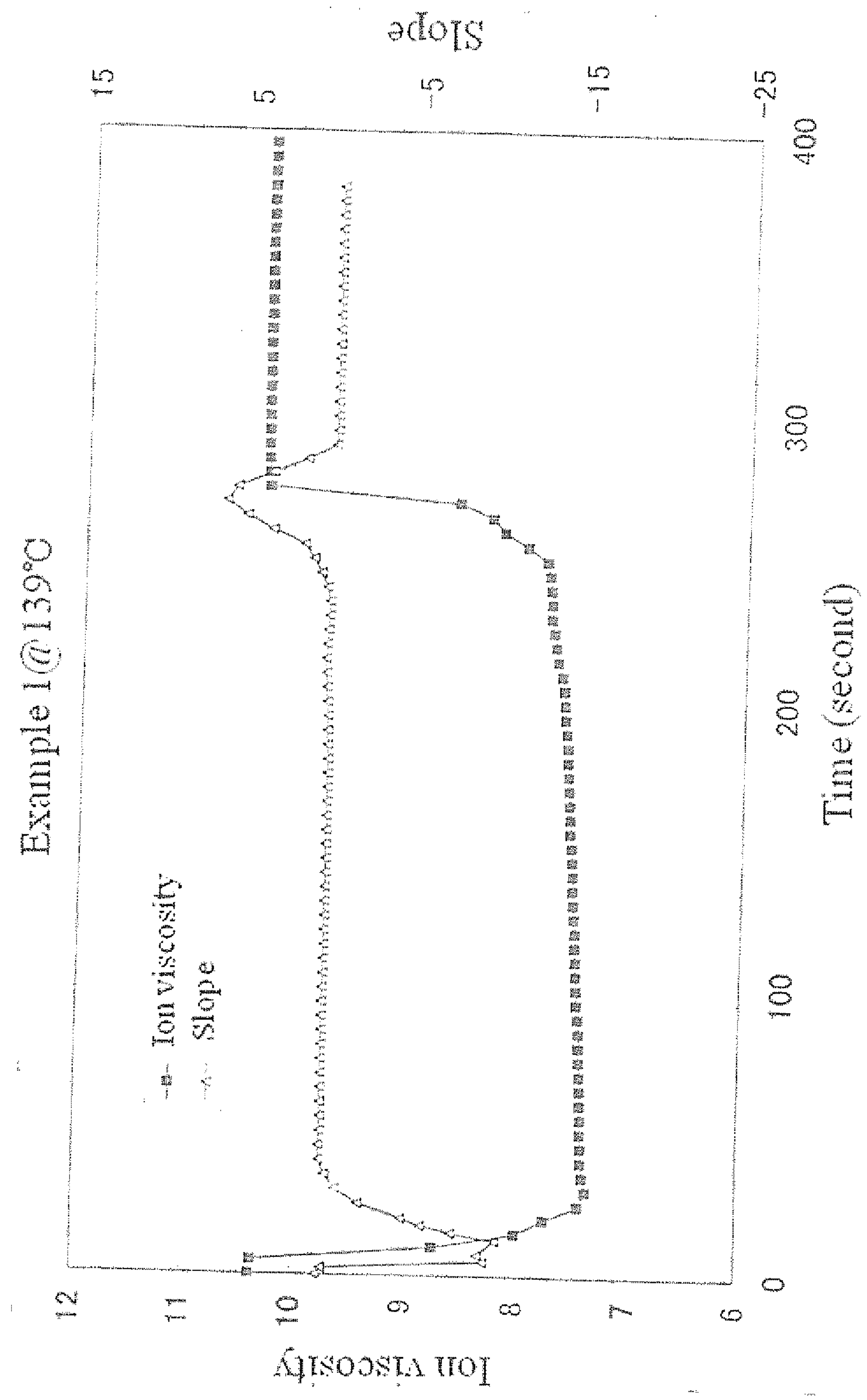
Example 1@139°C
Ion viscosity
Slope
Time (second)
0
100
200
300
400
Ion viscosity
12
11
10
9
8
7
6
Slope
15
5
-5
-15
-25

Fig. 8

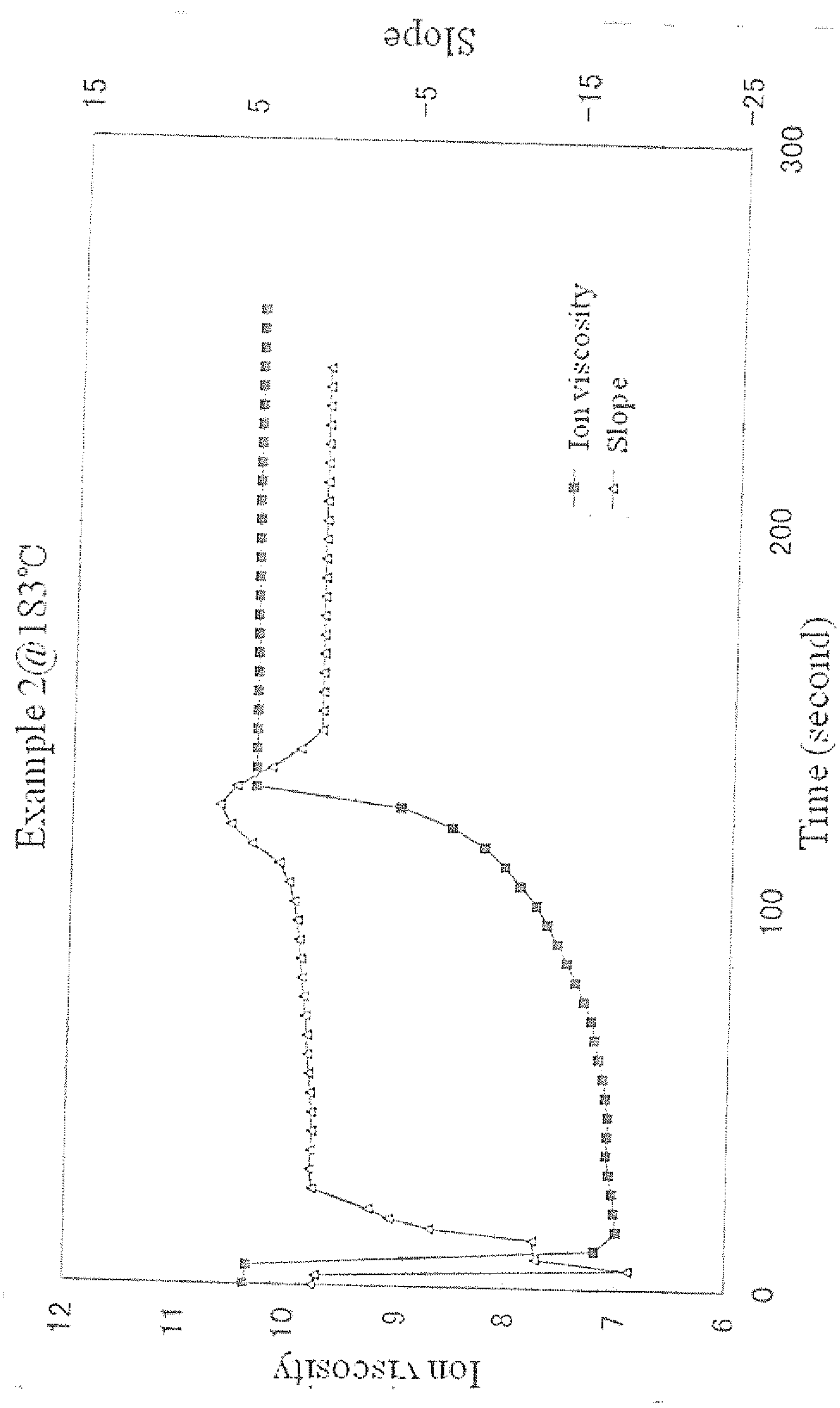
Example 2@183°C
Ion viscosity
Slope
Time (second)
0
100
200
300
12
11
10
9
8
7
6
15
5
-5
-15
-25

Fig. 9

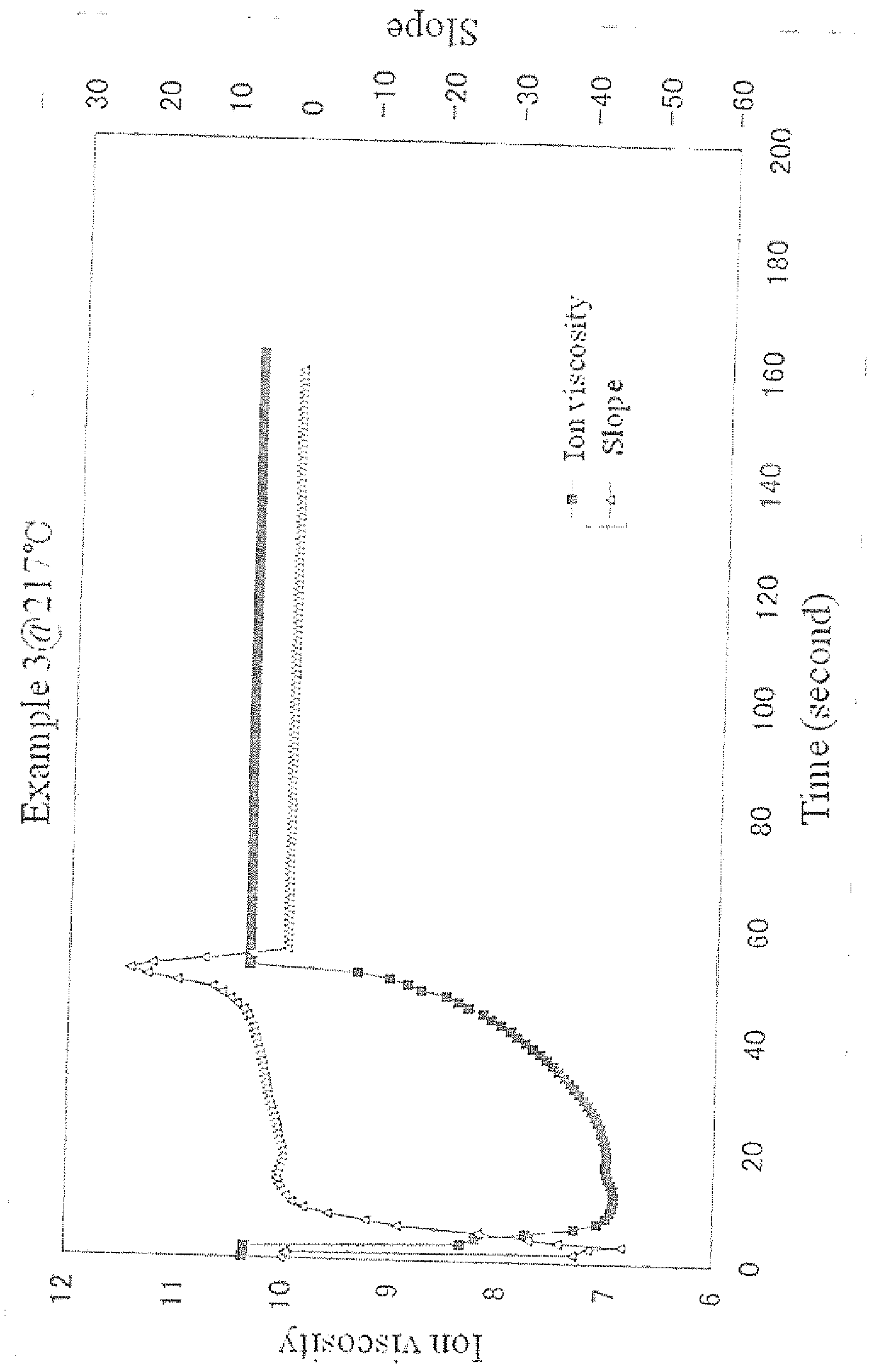

Example 3@217°C
Ion viscosity
Slope
Time (second)
0
20
40
60
80
100
120
140
160
180
200
12
11
10
9
8
7
6
30
20
10
0
-10
-20
-30
-40
-50
-60


Fig. 10

## INTERNATIONAL SEARCH REPORT

International application No.
PCT/JP2010/066914

A. CLASSIFICATION OF SUBJECT MATTER
See extra sheet.

According to International Patent Classification (IPC) or to both national classification and IPC

B. FIELDS SEARCHED

Minimum documentation searched (classification system followed by classification symbols)
C09J201/00, C09J7/02, C09J9/02, C09J11/04, C09J11/06, C09J133/02, C09J163/00, C09J171/10, C09J179/08, H01B5/16, H01L21/60, H01R11/01, H01R43/00, H05K1/14, H05K3/32, H05K3/36

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2000-219865 A (Seiko Epson Corp.), 08 August 2000 (08.08.2000), paragraphs [0028] to [0072]; fig. 1 to 9 & US 6356333 B1 | 1-23 |
| A | JP 2007-39567 A (KRI Inc.), 15 February 2007 (15.02.2007), paragraphs [0082] to [0356]; fig. 1 to 8 (Family: none) | 1-23 |

☐ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 26 October, 2010 (26.10.10) | 09 November, 2010 (09.11.10) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.
PCT/JP2010/066914

Continuation of A. CLASSIFICATION OF SUBJECT MATTER
(International Patent Classification (IPC))

*C09J201/00*(2006.01)i, *C09J7/02*(2006.01)i, *C09J9/02*(2006.01)i, *C09J11/04*(2006.01)i, *C09J11/06*(2006.01)i, *C09J133/02*(2006.01)i, *C09J163/00*(2006.01)i, *C09J171/10*(2006.01)i, *C09J179/08*(2006.01)i, *H01B5/16*(2006.01)i, *H01L21/60*(2006.01)i, *H01R11/01*(2006.01)i, *H01R43/00*(2006.01)i, *H05K1/14*(2006.01)i, *H05K3/32*(2006.01)i, *H05K3/36*(2006.01)i

(According to International Patent Classification (IPC) or to both national classification and IPC)

Form PCT/ISA/210 (extra sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 61276873 A
- JP 2004260131 A